(19) 

**Europäisches Patentamt**
**European Patent Office**
**Office européen des brevets**

(11) **EP 3 195 525 B1**

(12) **EUROPÄISCHE PATENTSCHRIFT**

(45) Veröffentlichungstag und Bekanntmachung des Hinweises auf die Patenterteilung:
**17.01.2018  Patentblatt 2018/03**

(21) Anmeldenummer: **16774486.1**

(22) Anmeldetag: **28.09.2016**

(51) Int Cl.:
*H04L 12/10* (2006.01)      *H04L 12/40* (2006.01)
*G01R 31/04* (2006.01)      *H01R 13/66* (2006.01)
*H01R 13/641* (2006.01)      *G06F 13/40* (2006.01)
*G06F 13/42* (2006.01)      *H01R 33/74* (2006.01)
*H01R 13/658* (2011.01)

(86) Internationale Anmeldenummer:
**PCT/EP2016/073123**

(87) Internationale Veröffentlichungsnummer:
**WO 2017/055355 (06.04.2017 Gazette 2017/14)**

(54) **EINGABE- / AUSGABEMODUL FÜR EIN BUSSYSTEM**

INPUT/OUTPUT MODULE FOR A BUSSYSTEM

BUS D'ENTRÉE/SORTIE POUR UN SYSTÈME DE BUS

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.10.2015   DE 102015116800**

(43) Veröffentlichungstag der Anmeldung:
**26.07.2017   Patentblatt 2017/30**

(73) Patentinhaber: **Beckhoff Automation GmbH**
**33415 Verl (DE)**

(72) Erfinder:
• **BÜTTNER, Holger**
**12157 Berlin (DE)**
• **RETTIG, Thomas**
**33378 Rheda-Wiedenbrück (DE)**

• **BECHTEL, Dirk**
**33649 Bielefeld (DE)**
• **JOST, Michael**
**32694 Dörentrup (DE)**
• **POHL, Christopher**
**33415 Verl (DE)**
• **BECKHOFF, Hans**
**33415 Verl (DE)**

(74) Vertreter: **Patentanwaltskanzlei WILHELM & BECK**
**Prinzenstraße 13**
**80639 München (DE)**

(56) Entgegenhaltungen:
**WO-A1-2015/007523      DE-A1-102011 087 828**

**Beschreibung**

Die Erfindung betrifft ein Eingabe-/Ausgabemodul für ein Bussystem. Die Erfindung betrifft des Weiteren ein Verfahren zum Betreiben eines Eingabe-/Ausgabemoduls für ein Bussystem. Die Erfindung betrifft des Weiteren ein Datenkabel sowie ein Computerprogramm.

Moderne Konzepte in der industriellen Automatisierungstechnik, das heißt der Steuerung und Überwachung von technischen Prozessen mit Hilfe von Software, beruhen auf der Idee einer zentralen Steuerung mit verteilter Sensor-/Aktorebene. Die Teilnehmer kommunizieren dabei untereinander und mit übergeordneten Systemen über industrielle Datennetzwerke, im Weiteren auch als Automatisierungsnetzwerke bezeichnet.

Das Ethernet ist der am weitesten verbreitete Kommunikationsstandard in lokalen Netzwerken (LAN) und wird vor allem durch die IEEE-Norm 802.3 festgelegt. Das Ethernet basiert auf einem LAN-Aufbau, bei dem eine Mehrzahl von Steuerknoten, zum Beispiel Computer oder Maschinen kabelgebunden miteinander verbunden sind, wobei das Ethernet-Protokoll die Verkapselung der zu übermittelnden Daten in Datenpaketen, im Weiteren auch als Telegramm bezeichnet, mit vorbestimmtem Format vornimmt. Es können dabei verschiedene Ethernet-Varianten eingesetzt werden, die sich in der Übertragungsrate, dem verwendeten Kabeltypen und der Leitungscodierung unterscheiden.

Die Kommunikation zwischen den Teilnehmern läuft bei industriell eingesetzten Ethernet-Netzwerken in der Regel über eine vier Adern aufweisende Datenleitung, wobei die vier Adern oft als zwei verdrillte Adernpaare ausgeführt sind. Das Verdrillen der Adernpaare reduziert das Übersprechen. Die beiden Adern eines Adernpaares werden immer gemeinsam verwendet, wobei über jeweils ein Adernpaar ein differentielles Datensignal übertragen wird. Manchmal werden auch alle vier Adern zusammen verdrillt, was zwar zu Nachteilen bei der elektromagnetische Verträglichkeit führt, aber den Vorteil einer höheren Flexibilität der Leitung hat.

Eine häufig zwingende Anforderung an Automatisierungsnetzwerke ist es, dass die Ausgänge einer Maschine, die Aktoren, jederzeit in einen sicheren Zustand gebracht werden können, ohne dabei die Möglichkeit zur Überwachung der Maschine zu verlieren. Die Sensoren und die Steuerung im Automatisierungsnetzwerk müssen deshalb unabhängig von den Aktoren betrieben werden können. Aus diesem Grund ist die Energieversorgung der Aktoren in der Regel getrennt von der Energieversorgung der Sensoren bzw. der Steuerung ausgeführt, um ein Abschalten der Aktorversorgung unabhängig von der Sensoren- bzw. Steuerungsversorgung durchzuführen.

Die im Automatisierungsnetzwerk benötigten Energieversorgungsleitungen werden in der Regel unabhängig von der Datenleitung verlegt, was mindestens zwei dedizierte Verkabelungen mit der entsprechenden Kontakttechnik nötig macht. In der Industrieautomation ist es aber wünschenswert, stets eine möglichst kostengünstige und einfache Verkabelung im Automatisierungsnetzwerk zu erreichen. Dies ist insbesondere dann von Bedeutung, wenn aufgrund von Umgebungsanforderungen eine gute Schirmung, eine hohe Schutzklasse oder eine hohe Temperaturbeständigkeit für die Verkabelung erforderlich sind. Die Verkabelung ist deshalb oft für einen relevanten hohen Anteil der Systemkosten verantwortlich.

Ein Ansatz, um Kosten bei der Verkabelung zu sparen, besteht darin, die Stromversorgung und die Datenübertragung in einer Verkabelung zu kombinieren. So kann mit Hilfe des sogenannten "Power over Ethernet" (PoE)-Standards über eine vieradrige Standard-Ethernet-Datenleitung zusätzlich zu den beiden differentiellen Datensignalen auf den zwei verdrillten Adernpaaren eine einzelne Spannung mit übertragen werden. Beim PoE-Standard wird hierfür ein speziell angepasster Ethernet-Übertrager verwendet, der die beiden für die Spannung benötigten Potentiale über eine Mittelanzapfung auf je einem Adernpaar anlegt. Da jedoch in der Industrieautomation häufig zwei getrennte Energieversorgungen erforderlich sind, eine für die Aktoren und die andere für die Sensoren bzw. die Steuerung, ist auch in einem PoE-System mit einer vieradrigen Datenleitung eine zusätzliche Verkabelung für eine zweite Energieversorgung erforderlich.

Das Konzept des PoE-Systems kann auf die Automatisierungstechnik übertragen werden, so dass einem Anwender die Möglichkeit geboten werden kann, automatisierungstechnische Geräte (zum Beispiel Eingabe-/Ausgabemodule) mit nur einer anstelle der sonst üblichen zwei Leitungen (Kommunikation und Spannungsversorgung) zu verbinden. Dazu werden zwei Versorgungsspannungen und zwei differentielle Datensignale auf derselben Leitung übertragen, wobei die Leitung zwei Adernpaare umfasst, und mit Hilfe einer elektronischen Schaltung voneinander getrennt.

Geräte, die diese Technologie (also das Übertragen von zwei Versorgungsspannungen und zwei differentiellen Datensignalen über dieselbe Leitung) beherrschen, dürfen nicht ohne weiteres mit Geräten verbunden werden, die diese Technologie nicht beherrschen, da bei den diese Technologie nicht beherrschenden Geräten sonst an den Kommunikationskomponenten eine Versorgungsspannung anliegen würde, was zu (irreparablen) Schäden im Gerät führen kann.

Die US 2013/0093444 A1 und die US 6,218,930 B1 zeigen jeweils eine Möglichkeit, Fähigkeiten von entfernten Geräten zu detektieren.

Aus der DE 10 2011 087828 A1 sind Fahrzeug-Netzwerke bekannt, die Power over Ethernet (PoE)-Systeme aufweisen. Bei einer Netzwerklösung wird auf mehreren parallel angeordneten Zwei-Adern-PoE-Systemen jeweils dieselbe Spannung angelegt. In einer weiteren Ausgestaltung werden zwei unterschiedliche Spannungen auf jeweils eine Gruppe von Zwei-Adern-PoE-Systeme aufgeprägt.

Aus der WO002015007523A1 ist ein Gleichstromverteilungssystem mit einer unipolaren Anschlusseinrichtungen zum elektrischen Anschluss einer elektrischen Vorrichtung an eine Stromversorgung bekannt, bei der die unipolare Anschlusseinrichtung eine Lastpräsenzdetektionseinheit zum Detektieren, ob ein Kontakt der elektrischen Vorrichtung an einen Anschlusseinrichtungskontakt angeschlossen wurde, und eine Polaritätsermittlungseinheit zum Ermitteln der Polarität des Kontakts der elektrischen Vorrichtung aufweist.

Die der Erfindung zugrunde liegende Aufgabe ist darin zu sehen, ein effizientes Konzept bereitzustellen, mittels welchem sichergestellt werden kann, dass ein Eingabe-/Ausgabemodul über eine Datenleitung einem entfernten weiteren Eingabe-/Ausgabemodul, welches mit dem Eingabe-/Ausgabemodul über die Datenleitung verbunden ist, keine Versorgungsspannung bereitstellt, wenn das entfernte weitere Eingabe-/Ausgabemodul nicht dafür ausgebildet ist, über die Datenleitung eine elektrische Versorgungsspannung zu empfangen.

Diese Aufgabe wird mittels des jeweiligen Gegenstands der unabhängigen Ansprüche gelöst. Vorteilhafte Ausgestaltungen der Erfindung sind Gegenstand von jeweils abhängigen Unteransprüchen.

Nach einem Aspekt wird ein Eingabe-/Ausgabemodul für ein Bussystem bereitgestellt, umfassend:

- eine erste Gleichspannungsversorgung und eine zweite Gleichspannungsversorgung,
- eine physikalische Schnittstelle, einen ersten Übertrager, einen zweiten Übertrager, eine erste induktive Baugruppe, eine zweite induktive Baugruppe, eine erste kapazitive Baugruppe, eine zweite kapazitive Baugruppe, eine erste Schalteinrichtung und eine zweite Schalteinrichtung,
- eine fünf Kontaktkelche aufweisende Buchse,
- wobei die fünf Kontaktkelche jeweils einen elektrischen Kontakt umfassen,
- wobei die erste Gleichspannungsversorgung über die erste induktive Baugruppe mittels der ersten Schalteinrichtung mit einem jeweiligen elektrischen Kontakt von zwei der fünf Kontaktkelche elektrisch verbindbar ist,
- wobei die zweite Gleichspannungsversorgung über die zweite induktive Baugruppe mittels der zweiten Schalteinrichtung mit einem jeweiligen elektrischen Kontakt von zwei anderen der fünf Kontaktkelche elektrisch verbindbar ist,
- wobei die physikalische Schnittstelle über den ersten Übertrager und über die erste kapazitive Baugruppe mit den jeweiligen elektrischen Kontakten von den zwei der fünf Kontaktkelche elektrisch verbunden ist, um ein erstes differenzielles Datensignal an die zwei elektrischen Kontakte der zwei der fünf Kontaktkelche anzulegen,
- wobei die physikalische Schnittstelle über den zweiten Übertrager und über die zweite kapazitive Baugruppe mit den jeweiligen elektrischen Kontakten von den zwei anderen der fünf Kontaktkelche elektrisch verbunden ist, um ein zweites differenzielles Datensignal an die zwei elektrischen Kontakte der anderen zwei der fünf Kontaktkelche anzulegen, und
- eine Messeinrichtung zur Detektion eines Steckers eines vieradrigen Datenkabels, die ausgebildet ist, bei einem in die Buchse eingesteckten Stecker zu detektieren, ob der Stecker vier oder fünf elektrische Kontaktstifte umfasst, die jeweils in einem der Kontaktkelche gesteckt und mit dem jeweiligen elektrischen Kontakt der Kontaktkelche elektrisch verbunden sind,
- wobei die Messeinrichtung ausgebildet ist, ausschließlich bei einer Detektion von fünf elektrischen Kontaktstiften die erste und die zweite Schalteinrichtung zu schließen, um eine jeweilige Versorgungsspannung der beiden Gleichspannungsversorgungen an die entsprechenden gesteckten Kontaktstifte des in der Buchse gesteckten Steckers über die jeweiligen elektrischen Kontakte der Kontaktkelche anzulegen.

Gemäß einem weiteren Aspekt wird ein Verfahren zum Betreiben eines Eingabe-/Ausgabemoduls bereitgestellt, umfassend die folgenden Schritte:

- Detektieren mittels der Messeinrichtung bei einem in die Buchse eingesteckten Stecker, ob der Stecker vier oder fünf elektrische Kontaktstifte umfasst, die jeweils in einem der Kontaktkelche gesteckt und mit dem jeweiligen elektrischen Kontakt der Kontaktkelche elektrisch verbunden sind,
- Schließen der beiden Schalteinrichtungen mittels der Messeinrichtung ausschließlich bei einer Detektion von fünf elektrischen Kontaktstiften, so dass aufgrund der geschlossenen Schalteinrichtungen eine jeweilige Versorgungsspannung der beiden Gleichspannungsversorgungen an die entsprechenden gesteckten Kontaktstifte des in der Buchse gesteckten Steckers über die jeweiligen elektrischen Kontakte der Kontaktkelche angelegt wird.

Gemäß einem weiteren Aspekt wird ein Datenkabel für ein Eingabe-/Ausgabemodul für ein Bussystem bereitgestellt, umfassend:

- zwei Adernpaare,
- einen Stecker mit fünf elektrischen Kontaktstiften,
- wobei vier der fünf elektrischen Kontaktstifte mit jeweils einer der Adern der zwei Adernpaare elektrisch verbunden sind.

Nach einem weiteren Aspekt wird ein Bussystem bereitgestellt, umfassend das Eingabe-/Ausgabemodul und das Datenkabel.

Nach einem anderen Aspekt wird ein Computerprogramm bereitgestellt, welches Programmcode zur Durchführung des Verfahrens zum Betreiben des Eingabe-/Ausgabemoduls umfasst, wenn das Computerprogramm auf einem Computer, insbesondere auf dem Eingabe-/Ausgabemodul, ausgeführt wird.

Die Erfindung umfasst insbesondere den Gedanken, ein Eingabe-/Ausgabemodul vorzusehen, welches ausgebildet ist, über ein vieradriges Datenkabel sowohl differenzielle Datensignale als auch eine Spannungsversorgung bereitzustellen. Aufgrund des Vorsehens der induktiven und kapazitiven Baugruppe ist es in vorteilhafter Weise ermöglicht, zwei galvanisch getrennte Gleichspannungen an die vier Adern des Datenkabels anzulegen. Mit nur einer einzigen Verkabelung, also dem Datenkabel, können so in vorteilhafter Weise parallel zwei galvanisch getrennte Gleichströme zusätzlich zu zwei differenziellen Datensignalen auf die beiden Adernpaare des Datenkabels übertragen werden. Eine Funktionalität des Bussystems wird so nicht verändert, so dass beliebige Busstrukturen wie Stern, Linie oder Ring möglich und nach anderen Ausführungsformen auch so vorgesehen sind.

Das Bussystem eignet sich nach einer Ausführungsform zum Einsatz in der Industrieautomation, ist also ein Bussystem einer Industrieautomation.

Mit Hilfe der über das vieradrige Datenkabel geführten, zwei galvanisch voneinander getrennten Gleichströmen kann eine separate Energieversorgung für Aktoren und/oder Sensoren und/oder einer Steuerung sichergestellt werden. Somit ist in vorteilhafter Weise ein Abschalten der Aktorversorgung unabhängig von der Sensor- bzw. Steuerungsversorgung möglich, so dass die zwingende Anforderung in industriellen Automatisierungsnetzwerken, jederzeit in der Lage zu sein, die Ausgänge einer Maschine, das heißt die Aktoren, in einen sicheren Zustand bringen zu können, ohne dabei die Kommunikation mit der Maschine zu unterbrechen, das heißt die Sensoren bzw. die Steuerung weiter ansprechen zu können, eingehalten werden kann.

Durch das Vorsehen der Messeinrichtung und der Schalteinrichtungen ist es in vorteilhafter Weise ermöglicht, ein weiteres Eingabe-/Ausgabemodul, welches nicht für eine Spannungsversorgung über dieselben Adernpaare eines Datenkabels ausgelegt ist, die zum Übertragen der Datensignale verwendet werden, dennoch an das erfindungsgemäße Eingabe-/Ausgabemodul anzuschließen. Denn das erfindungsgemäße Eingabe-/Ausgabemodul schließt nur die Schalteinrichtungen, wenn die Messeinrichtung detektiert, dass der angeschlossene Stecker des Datenkabels fünf elektrische Kontaktstifte aufweist. Somit ist es in vorteilhafter Weiser ermöglicht, für dieses weitere Eingabe-/Ausgabemodul ein Datenkabel zu verwenden, welches nur vier elektrische Kontaktstifte aufweist, um das weitere Eingabe-/Ausgabemodul an das erfindungsgemäße Eingabe-/Ausgabemodul anzuschließen. Denn in diesem Fall detektiert die Messeinrichtung lediglich vier elektrische Kontaktstifte des angeschlossenen Steckers des Datenkabels und wird insofern nicht die beiden Schalteinrichtungen schließen. Insofern ist eine elektrische Verbindung zwischen den Gleichspannungsversorgungen und zu den zwei sowie zu den zwei anderen der fünf Kontaktkelche elektrisch unterbrochen. Somit liegt also keine Gleichspannung an den zwei sowie an den zwei anderen der fünf Kontaktkelche an. Somit werden also in vorteilhafter Weise über die vier Kontaktkelche, welche mit der physikalischen Schnittstelle verbunden sind, lediglich differenzielle Datensignale übertragen. Somit wird also in vorteilhafter Weise verhindert, dass an Kommunikationskomponenten des weiteren Eingabe-/Ausgabemoduls eine elektrische Spannung anliegt. Somit wird in vorteilhafter Weise verhindert, dass diese Kommunikationskomponenten zerstört oder beschädigt werden.

Es kann also in vorteilhafter Weise ein Bussystem geschaffen werden, welches mehrere Eingabe-/Ausgabemodule umfasst, wobei diese mehreren Eingabe-/Ausgabemodule unterschiedliche Funktionalitäten aufweisen können: einige dieser Eingabe-/Ausgabemodule können eine so genannte PoE-Funktionalität aufweisen, das heißt eine Spannungsversorgung kann über die vier Adern des Datenkabels bereitgestellt werden, die auch die Datensignale übertragen. Andere der Eingabe-/Ausgabemodule weisen eine solche PoE-Funktionalität nicht auf und können dennoch an diese Eingabe-/Ausgabemodule angeschlossen werden, ohne Schaden zu nehmen.

Das heißt also insbesondere, dass erfindungsgemäß vorgesehen ist, dass das Datenkabel dazu dient, den angeschlossenen Teilnehmer, also das an das erfindungsgemäße Eingabe-/Ausgabemodul angeschlossene weitere Eingabe-/Ausgabemodul dahingehend zu identifizieren, ob das erfindungsgemäße Eingabe-/Ausgabemodul dem weiteren Eingabe-/Ausgabemodul eine Gleichspannung über die vier Adern bereitstellen darf oder nicht. Das heißt also insbesondere, dass basierend auf dem Datenkabel entschieden wird, ob der entfernte Teilnehmer versorgt werden darf oder nicht.

Nach einer Ausführungsform sind das erste differenzielle Datensignal und das zweite differenzielle Datensignal jeweils differenzielle Ethernet-Signale. Das Bussystem respektive das Eingabe-/Ausgabemodul eignen sich daher insbesondere zum Einsatz mit Ethernet als dem Kommunikationsstandard im Automatisierungsnetzwerk. Somit ist nach einer Ausführungsform ein Automatisierungsnetzwerk vorgesehen, welches das Bussystem umfasst.

Die Schalteinrichtungen wirken also als Schalter, um eine elektrische Verbindung zwischen der entsprechenden Gleichspannungsversorgung und den entsprechenden Kontaktkelchen zu schließen oder zu unterbrechen, also zu öffnen. Die Schalteinrichtungen können daher auch als Schaltereinrichtungen bezeichnet werden.

Nach einer Ausführungsform umfasst die Schalteinrichtung, also allgemein die erste und/oder zweite Schalteinrichtung, einen oder mehrere mechanische Schalter und/oder einen oder mehrere elektrische Schalter. Ein elektrischer Schalter ist zum Beispiel ein Transistor.

Nach einer Ausführungsform ist vorgesehen, dass die Messeinrichtung ausgebildet ist, eine elektrische Messspannung zwischen dem elektrischen Kontakt des fünften Kontaktkelchs, der verschieden von den zwei und den anderen zwei der fünf Kontaktkelche ist, und einem elektrischen Referenzkontakt anzulegen und einen zwischen dem Referenzkontakt und dem elektrischen Kontakt des fünften Kontaktkelchs fließenden elektrischen Strom zu messen, wobei der elektrische Referenzkontakt von dem elektrischen Kontakt des fünften Kontaktkelchs elektrisch isoliert ist, wobei die Messeinrichtung ausgebildet ist, die beiden Schalteinrichtungen zu schließen, wenn bei angelegter elektrischer Messspannung ein zwischen dem elektrischen Referenzkontakt und dem elektrischen Kontakt des fünften Kontaktkelchs fließender elektrischer Strom gemessen wird.

Dadurch wird insbesondere der technische Vorteil bewirkt, dass effizient bestimmt werden kann, ob die Versorgungsspannung freigeschaltet werden soll oder nicht. Das Prinzip hierbei beruht insbesondere darauf, dass im ungesteckten Zustand kein Strom zwischen dem fünften Kontaktkelch und dem elektrischen Referenzkontakt fließen darf, wenn die Messspannung anliegt. Wenn hingegen im gesteckten Zustand, also wenn der Stecker in der Buchse steckt, ein elektrischer Strom zwischen dem elektrischen Kontakt des fünften Kontaktkelchs und dem elektrischen Referenzkontakt fließt, so kann davon ausgegangen werden, dass für diesen Stromfluss der Stecker verantwortlich ist. Zum Beispiel umfasst der Stecker ein elektrisches Bauelement, welches einen elektrischen Kontaktstift mit einer Schirmung oder Abschirmung des Datenkabels verbindet. Das heißt also, dass eine elektrische Verbindung zwischen dem elektrischen Kontaktstift und der Schirmung geschaffen ist. Wenn nun genau dieser Kontaktstift in den fünften Kontaktkelch gesteckt wird, so wird eine elektrische Verbindung zwischen dem elektrischen Kontakt des fünften Kontaktkelchs mit dem elektrischen Referenzkontakt geschaffen, wenn der elektrische Referenzkontakt und die Schirmung beide auf Masse gelegt sind oder Masse entsprechen oder auf einem gemeinsamen Potential liegen, was somit auch nach einer Ausführungsform so vorgesehen ist.

Wenn also ein solches Datenkabel umfassend fünf Kontaktstifte detektiert wird, wird die Spannungsversorgung freigeschaltet.

In einer weiteren Ausführungsform ist vorgesehen, dass die Messeinrichtung einen Transistor umfasst, der ausgebildet ist, bei einem zwischen dem elektrischen Referenzkontakt und dem elektrischen Kontakt des fünften Kontaktkelchs fließenden elektrischen Stroms durchzuschalten, wobei die Messeinrichtung ausgebildet ist, ein Durchschalten des Transistors zu detektieren und bei Detektion eines Durchschaltens des Transistors die beiden Schalteinrichtungen zu schließen.

Dadurch wird insbesondere der technische Vorteil bewirkt, dass effizient erfasst werden kann, ob das Datenkabel vier oder fünf elektrische Kontaktstifte aufweist. Das Durchschalten des Transistors bewirkt ein effizient erzeugtes Signal für die Messeinrichtung, dass diese die Schalteinrichtungen schließen soll respektive darf. Durch das Vorsehen eines Transistors kann in vorteilhafter Weise bewirkt werden, dass das Messsignal mittels des Transistors sofort, also unmittelbar, zu einem Schaltsignal zum Schalten der Schalteinrichtungen verstärkt werden kann. Das ist eine besonders effiziente Verwendung eines Transistors als Schalter. Der Transistor bildet nach einer Ausführungsform die Messeinrichtung.

In einer anderen Ausführungsform ist vorgesehen, dass die Messeinrichtung ausgebildet ist, basierend auf der angelegten Messspannung und auf dem gemessenen elektrischen Strom zu ermitteln, was für ein im Stecker integriertes elektrisches Bauelement eine elektrische Verbindung zwischen dem elektrischen Referenzkontakt und dem elektrischen Kontakt des fünften Kontaktkelchs gebildet hat.

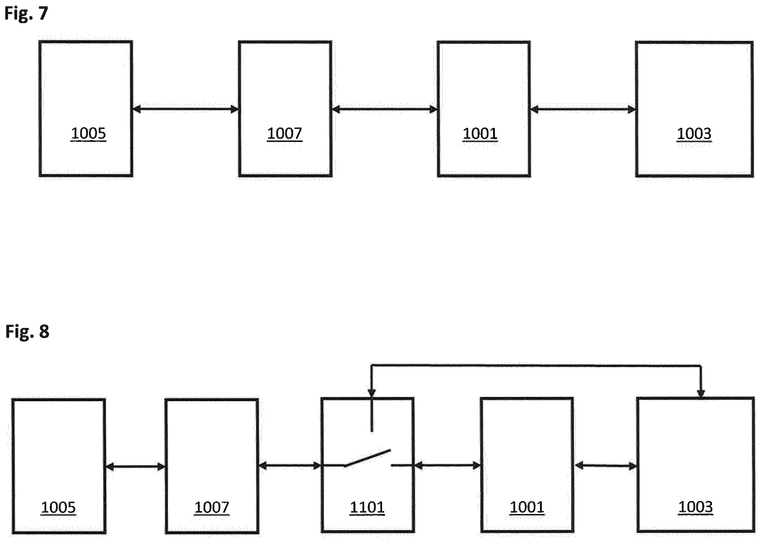

Dadurch wird insbesondere der technische Vorteil bewirkt, dass, basierend auf der Information, welches elektrische Bauelement die elektrische Verbindung hergestellt hat, das Eingabe-/Ausgabemodul effizient betrieben werden kann. Denn so kann zum Beispiel einem bestimmten elektrischen Bauelement ein bestimmter Betriebsparameter des Eingabe-/Ausgabemoduls zugeordnet sein. Das heißt also, dass, wenn ein bestimmtes elektrisches Bauelement detektiert wird, ein bestimmter Betriebsparameter verwendet wird, um das Eingabe-/Ausgabemodul zu betreiben. Zum Beispiel können unterschiedliche elektrische Bauelemente unterschiedliche Längen des Datenkabels anzeigen oder codieren, so dass entsprechend der Kabellänge des Datenkabels unterschiedliche Kommunikationsparameter gewählt werden. Das heißt also, dass dem elektrischen Bauelement eine bestimmte Information zugeordnet ist. Das heißt also, dass eine bestimmte Information in dem elektrischen Bauelement codiert ist. Anhand der gemessenen Eigenschaften ist nach einer weiteren Ausführungsform zusätzlich oder anstelle zu der Leitungslänge auch noch eine Stromtragfähigkeit codiert. Basierend darauf ist nach einer weiteren Ausführungsform vorgesehen, dass dann die Umschaltung des weiter unten beschriebenen Schalters 1101 (vgl. Fig. 8 bis 12 und entsprechende Figurenbeschreibung) durchgeführt wird, wobei dann in vorteilhafter Weise nach einer weiteren Ausführungsform auf eine Messung der Leitungslänge basierend auf Signallaufzeitmessungen verzichtet wird.

Die elektrischen Kontaktstifte können insbesondere als Pins oder Kontaktpins bezeichnet werden.

In einer weiteren Ausführungsform ist vorgesehen, dass die Messeinrichtung ausgebildet ist, eine elektrische Eigenschaft (oder mehrere elektrische Eigenschaften) des elektrischen Bauelements zu ermitteln.

Dadurch wird insbesondere der technische Vorteil bewirkt, dass über die Information der elektrischen Eigenschaft weitere Informationen im elektrischen Bauelement codiert werden können, die dann mittels der Messeinrichtung ausgelesen werden können. Das heißt also, dass basierend auf den ermittelten elektrischen Eigenschaften oder der ermittelten elektrischen Eigenschaft des elektrischen Bauelements das Eingabe-/Ausgabemodul betrieben wird. Somit ist zum Beispiel vorgesehen, dass bei unterschiedlichen elektrischen Eigenschaften das Eingabe-/Ausgabemodul unterschiedlich betrieben wird. Zum Beispiel kann eine Kabellänge des angeschlossenen Datenkabels in der elektrischen Eigenschaft codiert sein. Die vorstehend gemachten diesbezüglichen Ausführungen gelten analog auch für diese Ausführungsform.

In einer weiteren Ausführungsform ist vorgesehen, dass die Messeinrichtung ausgebildet ist, basierend auf der angelegten Messspannung und auf dem gemessenen elektrischen Strom eine Eigenschaft des angesteckten Datenkabels zu ermitteln.

Dadurch wir insbesondere der technische Vorteil bewirkt, dass eine Eigenschaft des angesteckten Datenkabels effizient ermittelt werden kann. Dies insbesondere dadurch, dass analog zu den vorstehend gemachten Ausführungen das elektrische Bauelement, welches die Verbindung zwischen dem elektrischen Kontakt des fünften Kontaktkelchs und dem elektrischen Referenzkontakt herstellt, eine codierte Information aufweisen kann. Codiert bedeutet hier also insbesondere, dass die Messeinrichtung oder allgemein das Eingabe-/Ausgabemodul weiß, dass bei einer bestimmten gemessenen Eigenschaft des elektrischen Bauelements das angesteckte Datenkabel eine bestimmte Eigenschaft aufweisen muss.

Nach einer Ausführungsform ist ein Datenspeicher vorgesehen, in welchem eine Zuordnungstabelle gespeichert ist, welche eine Zuordnung von gemessenen elektrischen Eigenschaften eines elektrischen Bauelements zu einer Eigenschaft eines Datenkabels umfasst.

In einer weiteren Ausführungsform ist vorgesehen, dass die Messeinrichtung einen elektrischen Schaltkontakt umfasst, wobei der elektrische Kontakt des fünften Kontaktkelchs, der verschieden von den zwei und den anderen zwei der fünf Kontaktkelche ist, beweglich gelagert ist, so dass bei einem Einstecken eines elektrischen Kontaktstifts des Steckers in den fünften Kontaktkelch der in den fünften Kontaktkelch eingesteckte elektrische Kontaktstift den beweglich gelagerten elektrischen Kontakt bewegt, so dass dieser den elektrischen Schaltkontakt betätigt, wobei die Messeinrichtung ausgebildet ist, bei betätigtem elektrischen Schaltkontakt die beiden Schalteinrichtungen zu schließen.

Dadurch wird insbesondere der technische Vorteil bewirkt, dass eine effiziente mechanische Erkennung des angesteckten Datenkabels ermöglicht ist. Denn nur bei einem Vorhandensein eines fünften Kontaktstifts kann der fünfte Kontaktkelch bewegt werden, um den elektrischen Schaltkontakt zu betätigen.

Sofern der Stecker des Datenkabels nur vier elektrische Kontaktstifte aufweisen sollte, kann der fünfte Kontaktkelch nicht bewegt werden, so dass insofern auch kein elektrischer Schaltkontakt betätigt werden kann, was insofern dazu führt, dass die Messeinrichtung nicht die beiden Schalteinrichtungen schließt. Dies insbesondere unter der Voraussetzung, dass Stecker und Buchse derart geometrisch ausgebildet sind, dass die vier elektrischen Kontaktstifte, an denen jeweils eine Ader der zwei Adernpaare angeschlossen sind, nur in die vier Kontaktkelche der Buchse passen, an deren jeweiligem elektrischen Kontakt die physikalische Schnittstelle angeschlossen ist respektive die Gleichspannungsversorgungen angeschlossen sind, was somit nach einer Ausführungsform so vorgesehen ist.

In einer weiteren Ausführungsform ist vorgesehen, dass die Messeinrichtung ausgebildet ist, über den elektrischen Kontakt des fünften Kontaktkelchs, der verschieden von den zwei und den anderen zwei der fünf Kontaktkelche ist, zu überprüfen, ob im Stecker ein programmierbarer Speicher als elektrisches Bauelement integriert ist, und basierend auf der Überprüfung die beiden Schalteinrichtungen zu schließen.

Dadurch wird insbesondere der technische Vorteil bewirkt, dass eine effiziente Erkennung des angeschlossenen Datenkabels ermöglicht ist. Ein Nichtvorhandensein eines elektrischen Bauelements wird dann zum Beispiel als Kriterium dafür genommen, die Schalteinrichtungen nicht zu schließen. Erst das Vorhandensein des elektrischen Bauelements, also hier dem programmierbaren Speicher, führt zu einem Schließen der Schalteinrichtungen. Das Vorsehen eines programmierbaren Speichers weist insbesondere den Vorteil auf, dass bestimmte Betriebsparameter und/oder Eigenschaften des Datenkabels in dem Speicher gespeichert sein können, was somit nach einer Ausführungsform auch vorgesehen ist. Diese Eigenschaften werden nach einer Ausführungsform mittels der Messeinrichtung ausgelesen, um basierend auf den ausgelesenen Eigenschaften das Eingabe-/Ausgabemodul zu betreiben.

Der programmierbare Speicher ist zum Beispiel ein PROM, also ein "Programmable Read Only Memory", also ein "Programmierbarer Nur-Lese-Speicher".

Das Überprüfen umfasst insbesondere, dass die Messeinrichtung versucht, eine Kommunikationsverbindung zu einem programmierbaren Speicher aufzubauen. Hierfür sendet die Messeinrichtung zum Beispiel eine Anfrage über den elektrischen Kontakt des fünften Kontaktkelchs. Eine Anfrage kann auch als ein "Request" bezeichnet werden. Wenn auf diese Anfrage nach einer vorbestimmten Zeit mittels der Messeinrichtung keine Antwort empfangen wird, so wird davon ausgegangen, dass kein programmierbarer Speicher im Stecker vorhanden ist. Sofern eine Antwort innerhalb einer vorbestimmten Zeit mittels der Messeinrichtung empfangen wird, so wird davon ausgegangen, dass ein Speicher im Stecker integriert ist. Die Schalteinrichtungen werden insofern geschlossen.

Ausführungsformen des Verfahrens respektive des Datenkabels respektive des Bussystems ergeben sich analog aus entsprechenden Ausführungsformen des Eingabe-/Ausgabemoduls und umgekehrt. Das heißt also, dass sich technische Funktionalitäten des Verfahrens respektive des Datenkabels respektive des Bussystems analog aus entsprechenden Funktionalitäten des Eingabe-/Ausgabemoduls ergeben und umgekehrt.

Nach einer Ausführungsform umfasst das Verfahren ferner:

- Anlegen mittels der Messeinrichtung einer elektrischen Messspannung zwischen dem elektrischen Kontakt des fünften Kontaktkelchs, der verschieden von den zwei und den anderen zwei der fünf Kontaktkelche ist, und einem elektrischen Referenzkontakt und
- Messen mittels der Messeinrichtung, ob zwischen dem Referenzkontakt und dem elektrischen Kontakt des fünften Kontaktkelchs ein elektrischer Strom fließt,
- Schließen mittels der Messeinrichtung der beiden Schalteinrichtungen, wenn bei angelegter elektrischer Messspannung ein zwischen dem elektrischen Referenzkontakt und dem elektrischen Kontakt des fünften Kontaktkelchs fließender elektrischer Strom gemessen wird.

In einer anderen Ausführungsform umfasst das Verfahren ferner:

- Schließen mittels der Messeinrichtung der beiden Schalteinrichtungen, wenn die Messeinrichtung ein Durchschalten des Transistors detektiert.

In einer Ausführungsform ist vorgesehen, dass der Transistor aufgrund des Durchschaltens ein Schaltsignal für die Schalteinrichtungen direkt erzeugt, so dass die Schalteinrichtungen ansprechend auf das Schaltsignal schließen.
Gemäß einer weiteren Ausführungsform umfasst das Verfahren ferner:

- Ermitteln mittels der Messeinrichtung basierend auf der angelegten Messspannung und auf dem gemessenen elektrischen Strom, was für ein im Stecker integriertes elektrisches Bauelement eine elektrische Verbindung zwischen dem elektrischen Referenzkontakt und dem elektrischen Kontakt des fünften Kontaktkelchs gebildet hat.

Nach einer weiteren Ausführungsform umfasst das Verfahren ferner:

- Ermitteln mittels der Messeinrichtung einer elektrischen Eigenschaft des elektrischen Bauelements.

Gemäß einer weiteren Ausführungsform umfasst das Verfahren ferner:

- Ermitteln mittels der Messeinrichtung basierend auf der angelegten Messspannung und auf dem gemessenen elektrischen Strom einer Eigenschaft des angesteckten Datenkabels.

In noch einer Ausführungsform umfasst das Verfahren ferner:

- Schließen der beiden Schalteinrichtungen mittels der Messeinrichtung, wenn der elektrische Schaltkontakt betätigt wird.

Gemäß einer weiteren Ausführungsform umfasst das Verfahren ferner:

- Überprüfen mittels der Messeinrichtung über den elektrischen Kontakt des fünften Kontaktkelchs, der verschieden von den zwei und den anderen zwei der fünf Kontaktkelche ist, ob im Stecker ein programmierbarer Speicher als elektrisches Bauelement integriert ist,
- Schließen der beiden Schalteinrichtungen mittels der Messeinrichtung basierend auf der Überprüfung.

In einer anderen Ausführungsform umfasst das Datenkabel eine Schirmung, wobei zwischen dem fünften elektrischen Kontaktstift und der Schirmung zumindest ein elektrisches Bauelement geschaltet ist.
Im gesteckten Zustand ist die Schirmung vorzugsweise mit dem elektrischen Referenzkontakt elektrisch verbunden. Der elektrische Referenzkontakt ist zum Beispiel die Masse.
Nach einer Ausführungsform ist das zumindest eine elektrische Bauelement ausgewählt aus der folgenden Gruppe von elektrischen Bauelementen: Widerstand, Induktivität, Kondensator, Diode, programmierbarer Speicher.
Die Formulierung "zumindest ein elektrisches Bauelement" umfasst insbesondere den Fall von mehreren elektrischen Bauelementen. Somit ist zum Beispiel vorgesehen, dass zwischen der Schirmung und dem fünften elektrischen Kontaktstift mehrere elektrische Bauelemente geschaltet sind. Zum Beispiel ist zwischen der Schirmung und dem fünften elektrischen Kontaktstift ein LC-Stromkreis oder ein RC-Stromkreis oder ein RLC-Stromkreis aufgebaut. L steht für Induktivität, R für einen elektrischen Widerstand (auch ohmscher Widerstand genannt) und C für einen Kondensator. Ein LC-Stromkreis umfasst somit eine Induktivität und einen Kondensator. Ein RC-Stromkreis umfasst einen Widerstand und einen Kondensator. Ein RLC-Stromkreis umfasst einen Widerstand, eine Induktivität und einen Kondensator.

Nach einer weiteren Ausführungsform ist vorgesehen, dass im programmierbaren Speicher eine Eigenschaft des Datenkabels gespeichert ist.

Nach einer Ausführungsform umfasst das Datenkabel zwei Stecker mit jeweils fünf elektrischen Kontaktstiften, wobei jeweils einer von vier der fünf elektrischen Kontaktstifte mit jeweils einer der Adern der zwei Adernpaare elektrisch verbunden ist.

Die zwei Stecker sind vorzugsweise an gegenüberliegenden Enden des Datenkabels angeordnet. Das Datenkabel kann somit in eine weitere Buchse eines weiteren Eingabe-/Ausgabemodul gesteckt werden.

Nach einer Ausführungsform sind die zwei Adernpaare jeweils als ein verdrehtes Adernpaar ausgebildet. Dadurch wird insbesondere der technische Vorteil bewirkt, dass ein effizienter Schutz gegenüber äußeren magnetischen Wechselfeldern und elektrostatischen Beeinflussungen erzielt werden kann.

Nach einer weiteren Ausführungsform ist vorgesehen, dass alle vier Adern der zwei Adernpaare zusammen verdrillt sind. Dadurch wird insbesondere der technische Vorteil bewirkt, dass das Datenkabel eine hohe Flexibilität aufweist.

Das Datenkabel kann auch als eine Datenleitung bezeichnet werden. Da das Datenkabel respektive die Datenleitung vier Adern umfassen, kann das Datenkabel auch als vieradriges Datenkabel und kann die Datenleitung auch als vieradrige Datenleitung bezeichnet werden.

Das eine der beiden Adernpaare bildet nach einer Ausführungsform einen ersten Kanal. Das andere der beiden Adernpaare bildet nach einer Ausführungsform einen zweiten Kanal. Dadurch ist also in vorteilhafter Weise bewirkt, dass eine zweikanalige Kommunikation zwischen zwei Eingabe-/Ausgabemodulen, die über das Datenkabel miteinander verbunden sind, erzielt werden kann.

Die Erfindung wird im Folgenden anhand von bevorzugten Ausführungsbeispielen näher erläutert. Hierbei zeigen:

Figur 1 ein Bussystem,

Figur 1a und 1b je einen Ausschnitt aus dem Bussystem der Figur 1,

Figur 2 eine Stecker-Buchse-Anordnung,

Figur 3 eine weitere Stecker-Buchse-Anordnung,

Figur 4 eine andere Stecker-Buchse-Anordnung,

Figur 5 die Stecker-Buchse-Anordnung der Figur 3 in einer anderen Ansicht,

Figur 6 ein Ablaufdiagramm eines Verfahrens zum Betreiben eines Eingabe-/Ausgabemoduls,

Figur 7 ein Blockdiagramm einer Ethernet-Anschaltung,

Figur 8 ein Blockdiagramm einer umschaltbaren Ethernet-Anschaltung,

Figur 9 ein Blockdiagramm zum Ermitteln einer Signallaufzeit zwischen zwei Teilnehmern eines Bussystems,

Figur 10 ein Blockdiagramm eines GBus,

Figur 11 ein Blockdiagramm eines GBus-Wandlers und

Figur 12 ein Blockdiagramm eines umschaltbaren GBus-Wandlers.

Im Folgenden können für gleiche Merkmale gleiche Bezugszeichen verwendet werden. Des Weiteren ist der Übersicht halber vorgesehen, dass nicht in allen Zeichnungen stets alle Merkmale eingezeichnet sind. Teilweise wird zum Beispiel für eine Gruppe von Merkmalen ein Platzhalter in Form eines geometrischen Objekts verwendet.

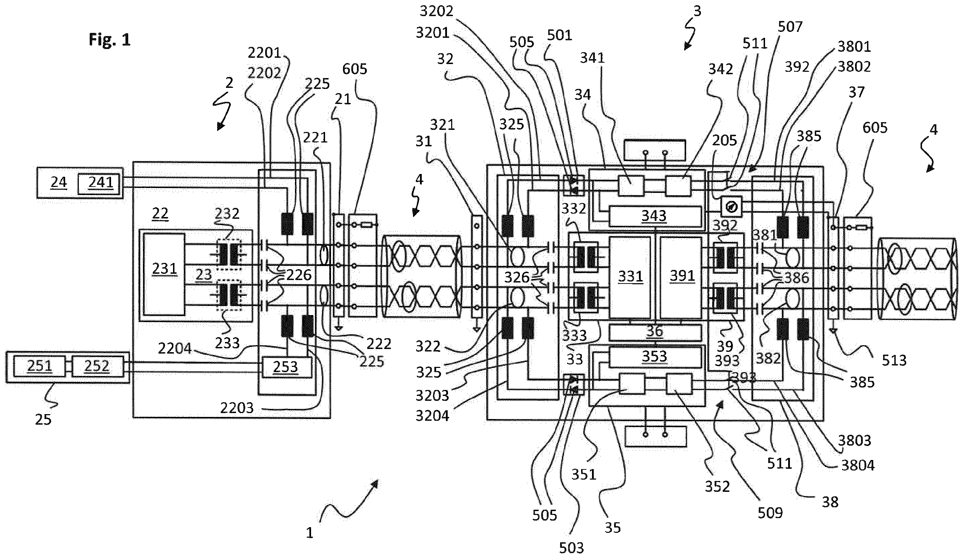

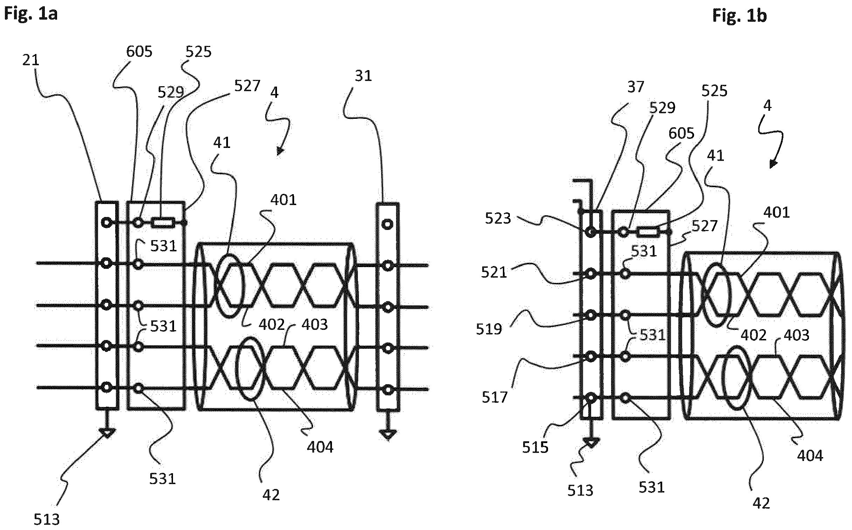

Figur 1 zeigt in schematischer Darstellung ein Bussystem 1 mit einem Einspeisemodul 2 und einem Verbrauchermodul 3, die über ein Datenkabel 4 miteinander verbunden sind, wobei das Datenkabel 4 auch als eine Datenleitung bezeichnet werden kann.

Das Verbrauchermodul 3 ist als ein Eingabe-/Ausgabemodul gemäß einer Ausführungsform der vorliegenden Erfindung ausgebildet, was nachstehend weiter erläutert wird. Der Einfachheit halber wird das Eingabe-/Ausgabemodul nachstehend auch als ein Verbrauchermodul 3 bezeichnet.

Das Datenkabel oder die Datenleitung 4 umfasst vier Adern 401, 402, 403, 404, wobei jeweils zwei Adern ein verdrilltes Adernpaar 41, 42 bilden. Es ist nach einer anderen Ausführungsform vorgesehen, dass alle vier Adern zusammen verdrillt sind, was zwar zu Nachteilen bei der elektromagnetische Verträglichkeit führt, aber den Vorteil einer höheren Flexibilität der Leitung hat.

Das Einspeisemodul 2 und das Verbrauchermodul 3, also das Eingabe-/Ausgabemodul, weisen jeweils eine Kontaktstelle 21, 31 auf, die die Datenleitung 4 mit dem Einspeisemodul 2 bzw. dem Verbrauchermodul 3 verbindet. Die Kontaktstelle 21 des Einspeisemoduls 2 bzw. die Kontaktstelle 31 des Verbrauchermoduls 3 umfassen jeweils fünf Anschlüsse, wobei vier der fünf Anschlüsse jeweils für jede Ader der Datenleitung 4 vorgesehen sind. Die Kontaktstelle 21 des Einspeisemoduls 2 respektive die Kontaktstelle 31 des Verbrauchermoduls ist als nicht näher dargestellte Buchse ausgebildet, wobei die fünf Anschlüsse jeweils als ein Kontaktkelch aufweisend einen elektrischen Kontakt ausgebildet sind. Die Kontaktstellen 21, 31 sind also als Steckkontakt ausgebildet, die über entsprechende Gegenstücke an der Datenleitung 4 mit den beiden verdrillten Adernpaaren 41, 42 verbunden sind.

Hierfür weist das Datenkabel 4 oder die Datenleitung 4 einen zu den Buchsen passenden Stecker mit fünf elektrischen Kontaktstiften auf. An vier der jeweiligen fünf elektrischen Kontaktstifte ist jeweils eine der vier Adern angeschlossen.

Die Buchsen sind zum Beispiel nach dem RJ45-Standard ausgebildet, sind also RJ45-Buchsen. Die Buchsen sind zum Beispiel als M8-Buchsen ausgebildet.

Die Stecker sind zum Beispiel nach dem RJ45-Standard ausgebildet, sind also RJ45-Stecker. Die Stecker sind zum Beispiel als M8-Stecker ausgebildet.

Somit bilden zum Beispiel ein Stecker und eine Buchse eine M8-Steckverbindung.

Weiterhin ist eine Sensor- und Steuerungsversorgung 24 und eine Aktorversorgung 25 vorgesehen, die mit dem Einspeisemodul 2 verbunden sind.

Das Einspeisemodul 2 umfasst ferner eine Kopplereinheit 22 und eine Datenübertragungseinheit 23. Die Kopplereinheit 22 setzt sich aus vier Leitungsabschnitten 2201, 2202, 2203, 2204 zusammen, die jeweils mit einem Anschluss der Kontaktstelle 21 verbunden sind und einen ersten und einen zweiten Zweig aufweisen. Im ersten Zweig jedes Leitungsabschnittes 2201, 2202, 2203, 2204 ist eine Induktivität 225 und im zweiten Zweig eine Kapazität 226 angeordnet. Jeweils zwei Leitungsabschnitte 2201, 2202, 2203, 2204 der Kopplereinheit 22 bilden ein Leitungsabschnittspaar 221, 222, das einem entsprechenden Adernpaar 41, 42 der Datenleitung 4 zugeordnet ist.

Die ersten Zweige der beiden Leitungsabschnittpaare 221, 222 mit den Induktivitäten 225 bilden erste Klemmpunkte und die zweiten Zweige der beiden Leitungsabschnittpaare 221, 222 mit den Kapazitäten 226 bilden zweite Klemmpunkte. Die ersten Klemmpunkte des ersten Zweiges des ersten Leitungsabschnittpaars 221 sind mit der Sensor- und Steuerungsversorgung 24 verbunden, die ein Netzteil 241 zum Einprägen einer ersten Gleichspannung aufweist. Die ersten Klemmpunkte des ersten Zweiges des zweiten Leitungsabschnittpaares 222 sind über einen Strombegrenzer 253 mit der Aktorversorgung 25 verbunden, die eine zweite Gleichspannung einprägt, wobei die Aktorversorgung 25 ein Netzteil 251 und einen Schalter 252 aufweist. Die beiden zweiten Klemmpunkte der beiden zweiten Zweige der beiden Leitungsabschnittpaare 221, 222 sind über die Kapazitäten 226 mit der Datenübertragungseinheit 23 verbunden, um ein erstes und ein zweites differenzielles Datensignal zu übertragen.

Die Datenübertragungseinheit 23 weist einen so genannten Ethernet Physical Layer (PHY) 231 auf, der eine physikalische Schnittstelle zwischen dem Einspeisemodul 2 und einer nachgeordneten Verarbeitungseinheit (nicht gezeigt) bildet und eine Kodierung respektive Dekodierung von Daten vornimmt. Der Ethernet Physical Layer 231 stellt das erste und das zweite differenzielle Datensignal zur Verfügung. Das erste differenzielle Datensignal wird über einen ersten Übertrager 232 von respektive zu den beiden zweiten Klemmpunkten des zweiten Zweiges des ersten Leitungsabschnittpaares 221 übertragen. Das zweite differenzielle Datensignal wird über einen zweiten Übertrager 233 an den beiden zweiten Klemmpunkten des zweiten Zweiges des zweiten Leitungsabschnittpaares 222 angelegt respektive von dort empfangen.

Das Einspeisemodul 2 ermöglicht es so, über jeweils ein Leitungsabschnittpaar 221, 222 der Kopplereinheit 22 sowohl eine Gleichspannung als auch ein differenzielles Datensignal in ein zugeordnetes Adernpaar 41, 42 der Datenleitung 4 zu übertragen. Das erste Leitungsabschnittpaar 221 der Kopplereinheit 22 im Einspeisungsmodul 2 legt die erste Gleichspannung über die Kontaktstelle 21 am ersten Adernpaar 41 der Datenleitung 4 an und überträgt gleichzeitig das erste differenzielle Datensignal. Das zweite Leitungsabschnittpaar 222 der Kopplereinheit 22 im Einspeisungsmodul 2 koppelt parallel die zweite Gleichspannung über die Kopplungsstelle 21 in das zweite Adernpaar 42 der Datenleitung 4 ein und überträgt gleichzeitig das zweite differenzielle Datensignal.

Durch die im ersten Zweig jedes Leitungsabschnittes 2201, 2202, 2203, 2204 angeordnete Induktivität 225 und die im zweiten Zweig jedes Leitungsabschnittes 2201, 2202, 2203, 2204 angeordnete Kapazität 226 werden die beiden differenziellen Datensignale und die beiden Gleichspannungen voneinander getrennt. Die Kapazitäten 226 blockieren dabei weitgehend die Gleichspannungen in den ersten Zweigen, während die Induktivitäten 225 die differenziellen Datensignale in den zweiten Zweigen im Wesentlichen unterdrücken. Die Induktivitäten respektive die Kapazitäten sind dabei so ausgelegt, dass eine ausreichend starke Dämpfung der differenziellen Datensignale im ersten Zweig erfolgt und gleichzeitig aber auch niedrige Frequenzen im zweiten Zweig des Leitungsabschnittpaars passieren können, die sich zum Beispiel durch einen Einsatz eines Autonegationsverfahren oder den Baseline-Wander-Effekt ergeben.

Im Verbrauchermodul 3 schließt sich an die Kontaktstelle 31 eine zum Einspeisungsmodul komplementäre Anordnung an, die sich aus einer Koppeleinheit 32, einer Datenübertragungseinheit 33, einer Sensor- und Steuerungsversorgung 34 und einer Aktorversorgung 35 zusammensetzt. Die Koppeleinheit 32 setzt sich aus vier Leitungsabschnitten 3201, 3202, 3203, 3204 zusammen, die jeweils mit einem Anschluss der Kontaktstelle 31 verbunden sind und einen ersten und einen zweiten Zweig aufweisen. Im ersten Zweig jedes Leitungsabschnittes 3201, 3202, 3203, 3204 ist wiederum eine Induktivität 325 und im zweiten Zweig eine Kapazität 326 angeordnet. Jeweils zwei Leitungsabschnitte 3201, 3202, 3203, 3204 der Koppeleinheit 32 bilden ein Leitungsabschnittpaar 321, 322, das einem entsprechenden Adernpaar 41, 42 der Datenleitung 4 zugeordnet ist.

Die ersten Zweige der beiden Leitungsabschnittpaare 321, 322 mit den Induktivitäten 325 bilden erste Klemmpunkte und die zweiten Zweige der beiden Leitungsabschnittpaare 321, 322 mit den Kapazitäten 326 bilden zweite Klemmpunkte. Die ersten Klemmpunkte des ersten Zweiges des ersten Leitungsabschnittpaars 321 sind mit der Sensor- und Steuerungsversorgung 34 verbunden, um mit dem ersten von dem Einspeisemodul 2 auf das dem ersten Adernpaar 41 der Datenleitung 4 übertragenen Gleichstrom versorgt zu werden. Die ersten Klemmpunkte des ersten Zweiges des zweiten Leitungsabschnittpaares 322 sind mit der Aktorversorgung 35 verbunden, um mit dem zweiten von dem Einspeisemodul 2 auf das dem zweiten Adernpaar 42 der Datenleitung 4 übertragenen Gleichstrom versorgt zu werden.

An der Sensor- und Steuerungsversorgung 34 im Verbrauchermodul 3 liegt somit, abgesehen von den Spannungsverlusten, die durch die Übertragungsstrecke und die zwischengeschalteten Bauelemente verursacht werden, die erste Gleichspannung, die von der Sensor- und Energieversorgung 24 in das Einspeisemodul 2 eingeprägt wird, an. Die Aktorversorgung 35 im Verbrauchermodul 3 wird dagegen unter Berücksichtigung der Spannungsverluste bei der Übertragung und durch die zwischengeschalteten Bauelemente mit der zweiten Gleichspannung, die von der Aktorversorgung 25 an das Einspeisemodul 2 angelegt wird, versorgt.

Die Sensor- und Steuerungsversorgung 34 und die Aktorversorgung 35 im Verbrauchermodul 3 können, wie in Fig.1 gezeigt, jeweils einer Last 342, 352 vorgeschaltet, eine Blockiereinheit 341, 351 aufweisen. Die Blockiereinheit 341, 351 verhindert, dass eine Rückwärtsspeisung des Gleichstroms von der Last 342 in der Sensor- und Steuerungsversorgung 34 bzw. der Last 352 in der Aktorversorgung 35 im Verbrauchermodul 3 zum Netzteil 241 in der Sensor- und Steuerungsversorgung 24 bzw. zum Netzteil 251 in der Aktorversorgung 25 im Einspeisemodul 2 erfolgt.

Der Sensor- und Steuerungsversorgung 34 und der Aktorversorgung 35 vorgeschaltet ist jeweils ein Rückspeiseschutz 501, 503. Der Rückspeiseschutz 501, 503 umfasst jeweils zwei Dioden 505, die in den Leitungsabschnitten 3201, 3202, 3203, 3204 geschaltet sind. Anstelle der Dioden 505 ist in einer weiteren Ausführungsform vorgesehen, dass FETs (Feldeffekttransistoren) verwendet werden. FETs weisen gegenüber Dioden geringere Verluste bei gleicher Funktion auf.

Die Diode 505 im Leitungsabschnitt 3201 sperrt einen Stromfluss von der Kontaktstelle 31 in Richtung der Sensor- und Steuerungsversorgung 34. Die Diode 505 im Leitungsabschnitt 3202 sperrt einen Stromfluss von der Sensor- und Steuerungsversorgung 34 in Richtung Kontaktstelle 31. Die Diode 505 im Leitungsabschnitt 3203 sperrt einen Stromfluss von der Aktorversorgung 35 in Richtung Kontaktstelle 31. Die Diode 505 im Leitungsabschnitt 3204 sperrt einen Stromfluss von der Kontaktstelle 31 in Richtung der Aktorversorgung 35.

Der Rückspeiseschutz 501, 503 ist optional. In einer nicht gezeigten Ausführungsform sind diese nicht vorgesehen.

Die beiden zweiten Klemmpunkte der beiden zweiten Zweige der beiden Leitungsabschnittpaare 321, 322 sind mit einer Datenübertragungseinheit 33 verbunden, um das von dem Einspeisemodul 2 übertragene erste und das zweite differenzielle Datensignal zu empfangen respektive das erste und zweite differenzielle Datensignal an das Einspeisemodul 2 zu senden. Die Datenübertragungseinheit 33 weist hierzu analog zur Datenübertragungseinheit 23 im Einspeisemodul 2 einen so genannten Ethernet Physical Layer 331 auf, der eine physikalische Schnittstelle zwischen dem Verbrauchermodul 3 und einer nachgeordneten Verarbeitungseinheit 36 bildet und eine Kodierung bzw. Dekodierung von Daten vornimmt. Der Ethernet Physical Layer 331 empfängt respektive sendet das erste differenzielle Datensignal über einen ersten Übertrager 332, der an den beiden zweiten Klemmpunkten des zweiten Zweiges des ersten Leitungsabschnittpaares 321 angeschlossen ist. Das zweite differenzielle Datensignal wird über einen zweiten Übertrager 333, der an den beiden zweiten Klemmpunkten des zweiten Zweiges des zweiten Leitungsabschnittpaares 322 angeschlossen ist.

Mit diesem Aufbau ist es somit möglich, über jeweils zwei vorzugsweise verdrillte Adern in der Datenleitung 4 zwischen dem Einspeisemodul 2 und dem Verbrauchermodul 3 parallel eine Gleichspannung und ein differenzielles Datensignal zu übertragen, wobei die beiden Gleichspannungen voneinander galvanisch getrennt sind.

Zum Einsatz des Bussystems 1 in der Industrieautomation ist es notwendig, die Energieversorgung der Aktoren im Bussystem über das zweite (verdrillte) Adernpaar 42 in der Datenleitung 4 schaltbar auszugestalten. Die Aktorversorgung 25 umfasst deshalb den Schalter 252, der dem Netzteil 251 nachgeordnet ist und der ein Abschalten der Aktorversorgung 25 unabhängig von der Sensoren- bzw. Steuerungsversorgung 24 ermöglicht. Durch das Abschalten der Aktorversorgung 25 können die Aktoren im Automatisierungsnetzwerk in einen sicheren Zustand gebracht werden, ohne dabei die Kommunikation unterbrechen zu müssen. Die Sensoren bzw. die Steuerung werden weiter mit dem ersten Gleichstrom von der Sensor- und Steuerungsversorgung 24 im Einspeisemodul 2 beliefert und sind über das erste und zweite differenzielle Datensignal ansprechbar.

Der Schalter 252 der Aktorversorgung 25 ist nach einer Ausführungsform als prellarmer Schalter ausgebildet, um zu verhindern, dass der Schalter beim Betätigen aufgrund des mechanischen Aufbaus mehrfach schließt und öffnet. Ein solches mehrfaches Schließen und Öffnen führt zu einem erhöhten Kontaktabrieb und damit zu einem schnellen Ausfall, insbesondere dann, wenn gleichzeitig hohe Überströme auftreten. Als prellarmer Schalter kann beispielsweise ein RS-Flip-Flop verwendet werden.

Um zu verhindern, dass Schaltvorgänge der Aktorversorgung 25 die Datenkommunikation über das zweite verdrillte Adernpaar 42 stören, ist in das Einspeisemodul 2 der Strombegrenzer 253 integriert, der mit dem Schalter 252 der Aktorversorgung 25 verbunden ist. Mit dem Strombegrenzer 253 kann verhindert werden, dass ein beim Einschaltvorgang kurzfristig auftretender hoher Anlaufstrom des nachgeschalteten Verbrauchermoduls den zulässigen Sättigungsstrom der Induktivitäten 225 in den ersten Zweigen des zweiten Leitungsabschnittpaares 222 übersteigt und die Induktivitäten 225 ihre induktiven Eigenschaften nahezu vollständig verlieren. Dies würde dann dazu führen, dass das differenzielle Datensignal auf den zweiten Zweigen des zweiten Leitungsabschnittpaares 222 massiv beeinflusst wird und die Kommunikation über das zweite verdrillte Adernpaar 42 in der Datenleitung 4 zusammenbricht.

Der Strombegrenzer 253 sorgt neben einer Begrenzung des Anlaufstroms auch für eine Begrenzung des maximalen Dauerstroms durch die Induktivitäten 225 in den ersten Zweigen des zweiten Leitungsabschnittpaares 222, soweit seine thermische Belastung es zulässt. Der maximal zulässige Dauerstrom durch die Induktivitäten 225 wird durch deren Ohmschen Widerstand und die thermischen Eigenschaften bestimmt. Wenn der maximal zulässige Dauerstrom dauerhaft überschritten wird, verlieren die Induktivitäten 225 ihre induktiven Eigenschaften und können zerstört werden. Der Einsatz eines Strombegrenzers ist in der Regel nur im Einspeisemodul 2 notwendig.

In dem in Figur 1 gezeigten Verbrauchermodul 3, also dem Eingabe-/Ausgabemodul, weist sowohl die Sensor- und Steuerungsversorgung 34 als auch die Aktorversorgung 35 eine Spannungsüberwachungseinheit 343, 353 auf, die jeweils an die zwei Durchleitungen in der Sensor- und Steuerungsversorgung 34 bzw. der Aktorversorgung 35 angeklemmt sind. Mit den beiden Spannungsüberwachungseinheiten 343, 353 kann überwacht werden, ob sowohl die Sensor- und Steuerungsversorgung 34 als auch die Aktorversorgung 35 im Verbrauchermodul 3 jeweils im spezifizierten Bereich der Betriebsspannung arbeiten.

Bei dem in Figur 1 gezeigten Aufbau ist nach einer Ausführungsform vorgesehen, dass das Einspeisemodul 2 eine Reihe von hintereinander geschalteten Verbrauchermodulen versorgt, die dem in Figur 1 gezeigten Verbrauchermodul 3 entsprechen. Das Verbrauchermodul 3 ist, wie in Figur 1 dargestellt, im Wesentlichen symmetrisch aufgebaut, um die beiden vom Einspeisemodul 2 auf den beiden verdrillten Adernpaare 41, 42 der Datenleitung 4 gelieferten Gleichströme bzw. die beiden differenziellen Datensignale auf ein weiteres Verbrauchermodul (nicht gezeigt) zu übertragen. Das weitere Verbrauchermodul ist dabei wiederum über eine Datenleitung mit vier Adern, wobei jeweils zwei Adern ein verdrehtes Adernpaar bilden, an eine zweite Kontaktstelle 37 des Verbrauchermoduls 3 angeschlossen. Die zweite Kontaktstelle 37 ist analog zur Kontaktstelle 31 gebildet.

Das Verbrauchermodul 3 weist eine zweite Kopplereinheit 38 auf, die komplementär zur ersten Koppplereinheit 32 ausgelegt ist. Die zweite Koppplereinheit 38 setzt sich aus vier Leitungsabschnitten 3801, 3802, 3803, 3804 zusammen, die jeweils mit einem Anschluss (einem elektrischen Kontakt von vier Kontaktkelchen) der zweiten Kontaktstelle 37 verbunden sind und einen ersten und einen zweiten Zweig aufweisen. Im ersten Zweig jedes Leitungsabschnittes 3801, 3802, 3803, 3804 ist wiederum eine Induktivität 385 und im zweiten Zweig eine Kapazität 386 angeordnet. Jeweils zwei Leitungsabschnitte 3801, 3802, 3803, 3804 der Koppplereinheit 38 bilden ein Leitungsabschnittpaar 381, 382, das einem entsprechenden Adernpaar der über die zweite Kontaktstelle 37 anschließbaren Datenleitung 4 zugeordnet ist.

Die ersten Zweige der beiden Leitungsabschnittpaare 381, 382 mit den Induktivitäten 385 bilden erste Klemmpunkte und die zweiten Zweige der beiden Leitungsabschnittpaare 381, 382 mit den Kapazitäten 386 bilden zweite Klemmpunkte. Die ersten Klemmpunkte des ersten Zweiges des ersten Leitungsabschnittpaars 221 sind mit der Sensor- und Steuerungsversorgung 34 verbunden, um die erste Gleichspannung anzulegen und so den von dem Einspeisemodul 2 gelieferten ersten Gleichstrom über die beiden Leitungsabschnittpaare 381, 382 an eine Sensor- und Steuerungsversorgung des nächsten Verbrauchermoduls (nicht gezeigt) zu übertragen. Die ersten Klemmpunkte des ersten Zweiges des zweiten Leitungsabschnittpaares 222 sind mit der Aktorversorgung 35 verbunden, die die zweite Gleichspannung einprägt. Der von dem Einspeisemodul 2 gelieferte zweite Gleichstrom wird so über das Leitungsabschnittpaare 382 an eine Aktorversorgung des nächsten Verbrauchermoduls (nicht gezeigt) weitergeleitet.

Die beiden zweiten Klemmpunkte der beiden zweiten Zweige der beiden Leitungsabschnittpaare 381, 382 sind mit einer zweiten Datenübertragungseinheit 39 verbunden, die das erste und zweite differenzielle Datensignal überträgt. Die zweite Datenübertragungseinheit 39 weist hierzu analog zur ersten Datenübertragungseinheit 33 im Verbrauchermodul 3 einen so genannten Ethernet Physical Layer 391 auf, der eine physikalische Schnittstelle zur Verarbeitungseinheit 36 darstellt und eine Kodierung bzw. Dekodierung von Daten vornimmt. Der Ethernet Physical Layer 391 sendet bzw. empfängt das erste differenzielle Datensignal über einen ersten Übertrager 392, der an den beiden zweiten Klemmpunkten des zweiten Zweiges des ersten Leitungsabschnittpaares 381 angeschlossen ist. Das zweite differenzielle Datensignal wird über einen zweiten Übertrager 393, der an den beiden zweiten Klemmpunkten des zweiten Zweiges des zweiten Leitungsabschnittpaares 382 angeschlossen ist, vom bzw. zum Ethernet Physical Layer 391 übertragen.

Der Ethernet Physical Layer 331 der ersten Übertragungseinheit 33 ist mit dem Ethernet Physical Layer 391 der zweiten Übertragungseinheit 39 über die zwischengeschaltete Verarbeitungseinrichtung 36 im Verbrauchermodul 3 verbunden. Die beiden differenziellen Datensignale können so nach Verarbeitung durch die zwischengeschaltete Verarbeitungseinrichtung 36 vom ersten Ethernet Physical Layer 331 auf den zweiten Ethernet Physical Layer 391 und zurück übertragen und damit durch das Verbrauchermodul 3 hindurch geschleift und zu bzw. von einer Datenübertragungseinheit des nächsten Verbrauchermoduls (nicht gezeigt) übertragen werden.

Im Einspeisemodul 2 bzw. den Verbrauchermodulen 3 des Bussystems 1 werden jeweils Kopplereinheiten mit einer Kombination aus induktiven und kapazitiven Baugruppen eingesetzt, um zwei galvanisch getrennte Gleichspannungen an einer vieradrigen Datenleitung anzulegen. Mit nur einer einzelnen Verkabelung, die aus der vieradrigen Datenleitung besteht, können parallel zwei galvanisch getrennte Gleichströme zusätzlich zu zwei differenziellen Datensignalen auf die beiden Adernpaare der Datenleitung übertragen werden. Die Funktionalität des Bussystems wird hinsichtlich der Datenübertragung nicht verändert.

Beim Einsatz der Ethernet-Übertragungsphysik wird die Auslegung der Kapazitäten in dem Leitungsabschnittpaar der Kopplereinheit durch die untere Grenzfrequenz des zu übertragenden differenziellen Datensignals bestimmt, welche wiederum durch den Autonegotiationsprozess vorgeben wird. Diese Grenzfrequenz liegt bei ca. 2 MHz. Die Kapazitäten müssen dann so ausgelegt werden, das sie bei dieser Grenzfrequenz noch nicht in die Sättigung gehen, so dass Kapazitäten mit 470 nF benötigt werden. Bevorzugt ist dabei eine Ausführungsform mit Kapazitäten 1 $\mu$F, um eventuelle Effekte einer schwankenden Versorgungsspannung auszugleichen.

Bei der Auslegung der Induktivitäten der Kopplereinheit insbesondere im Verbrauchermodul ist entscheidend, ob wie in Figur 1 gezeigt, eine Durchleitung der beiden Gleichspannungen erfolgt, so dass die Induktivitäten der beiden Kopplereinheiten im Verbrauchermodul miteinander in Verbindung stehen. Dadurch werden auch die beiden differenziellen Datensignale gekoppelt. Die Induktivitäten der Kopplereinheiten müssen dann so gewählt werden, dass Übersprechen verhindert wird. Darüber hinaus sind auch die Eigenschaften der Ethernet Physical Layer in der Datenübertragungseinheit für die Auslegung der Induktivitäten von Bedeutung. In einer Ausführungsform wird eine Induktivität von größer 3$\mu$H, vorzugsweise 6,8 $\mu$H verwendet.

Das Eingabe-/Ausgabemodul 3, also das Verbrauchermodul 3, weist ferner eine erste Schalteinrichtung 507 und eine zweite Schalteinrichtung 509 auf. Beide Schalteinrichtung 507, 509 umfassen jeweils zwei Schalter 511, die jeweils in einem der vier Leitungsabschnitte 3801, 3802, 3803, 3804 zwischen der Sensor- und Steuerungsversorgung 34 respektive der Aktorversorgung 35 und den elektrischen Kontakten der Kontaktkelche der als Buchse ausgebildete Kontaktstelle 37 geschaltet sind. Das heißt, dass jeder der vier Leitungsabschnitte 3801, 3802, 3803, 3804 einen Schalter 511 umfasst. Dadurch kann in vorteilhafter Weise eine elektrische Verbindung zwischen der Sensor- und Steuerungsversorgung 34 respektive der Aktorversorgung 35 und den Kontakten der Kontaktkelche unterbrochen oder geschlossen werden.

Die Schalter 511 sind zum Beispiel als mechanische Schalter ausgebildet. Zum Beispiel sind die Schalter 511 als elektrische Schalter, zum Beispiel als ein Transistor, ausgebildet.

Das Eingabe-/Ausgabemodul 3 umfasst des Weiteren eine Messeinrichtung 205. Die Messeinrichtung 205 ist ausgebildet, die Schalteinrichtungen 507, 509 zu öffnen oder zu schließen. Das heißt, dass die Messeinrichtung 205 ausgebildet ist, die Schalter 511 zu öffnen oder zu schließen.

Die Messeinrichtung 205 ist ferner ausgebildet, eine Messspannung zwischen einem elektrischen Kontakt des fünften Kontaktkelchs und einem elektrischen Referenzkontakt 513 anzulegen.

Der Übersicht halber und für die weitere Beschreibung sind die fünf Kontaktkelche symbolisch als Kreis dargestellt und mit den Bezugszeichen 515, 517, 519, 521, 523 durchnummeriert.

Der Leitungsabschnitt 3803 führt zum elektrischen Kontakt des Kontaktkelchs 517. Der Leitungsabschnitt 3804 führt zum elektrischen Kontakt des Kontaktkelchs 515. Der Leitungsabschnitt 3802 führt zum elektrischen Kontakt des Kontaktkelchs 521. Der Leitungsabschnitt 3801 führt zum elektrischen Kontakt des Kontaktkelchs 519.

An den elektrischen Kontakt des fünften Kontaktkelchs, also des Kontaktkelchs 523, und an den elektrischen Referenzkontakt 513 wird die Messspannung angelegt. Der elektrische Referenzkontakt 513 ist zum Beispiel auf Masse gelegt.

In der in der Figur 1 gezeigten Anordnung ist der elektrische Kontakt des Kontaktkelchs 515 ebenfalls auf den elektrischen Referenzkontakt 513 gelegt, also zum Beispiel auf Masse. In nicht gezeigten Ausführungsformen ist vorgesehen, dass ein elektrischer Kontakt eines anderen der vier Kontaktkelche 515, 517, 519, 521 auf den elektrischen Referenzkontakt 513, also zum Beispiel auf Masse gelegt, ist.

Es ist ein Datenkabel vorgesehen, welches in die Buchse 37 gesteckt ist und ebenfalls mit dem Bezugszeichen 4 gekennzeichnet ist. Dieses Datenkabel ist analog zum Datenkabel 4 zwischen dem Einspeisemodul 2 und dem Verbrauchermodul 3 ausgebildet. Es umfasst einen in der als Stecker ausgebildeten Kontaktstelle 605 integrierten elektrischen Widerstand 525, der zwischen dem fünften Kontaktstift 529 und einer Schirmung 527 des Datenkabels 4 geschaltet ist. Der fünfte Kontaktstift ist derjenige Kontaktstift, an dem keine der vier Adern angeschlossen ist.

Wenn der Stecker 605 des Datenkabels in die Buchse 37 eingesteckt wird, so nehmen die vier Kontaktkelche 515, 517, 519, 521 jeweils einen entsprechenden Kontaktstift auf. Der fünfte Kontaktkelch 523 nimmt den fünften Kontaktstift 529 auf. Die Schirmung 527 ist im eingesteckten Zustand mit dem elektrischen Referenzkontakt 513 verbunden. Somit ist also eine elektrische Verbindung über den elektrischen Widerstand 525 zwischen dem Referenzkontakt 513 und dem elektrischen Kontakt des fünften Kontaktkelchs 523 gebildet.

Die weiteren vier elektrischen Kontaktstifte des Steckers 605 sind der Einfachheit halber mit dem gleichen Bezugszeichen, dem Bezugszeichen 531 gekennzeichnet.

Aufgrund der angelegten Messspannung fließt ein elektrischer Strom zwischen dem Referenzkontakt 513 und dem elektrischen Kontakt des fünften Kontaktkelchs 523. Diesen elektrischen Strom misst die Messeinrichtung 205 und erkennt dadurch, dass das angeschlossene Datenkabel 4 fünf elektrische Kontaktstifte aufweisen muss. Dies bedeutet für die Messeinrichtung 205, dass das dem in Figur 1 gezeigten Eingabe-/Ausgabemodul 3 nachgeschalteten Eingabe-/Ausgabemodul (nicht gezeigt) ausgebildet ist, über die vier Adern nicht nur die Datensignale, sondern auch die Gleichspannungen zu empfangen (PoE-Funktionalität). Daher schließt die Messeinrichtung 205 die vier Schalter 511. Die Versorgungsspannungen können somit in vorteilhafter Weise an den nächsten Teilnehmer, das weitere Eingabe-/Ausgabemodul, weitergereicht werden.

Falls das nachgeschaltete Eingabe-/Ausgabemodul nicht für eine PoE-Funktionalität ausgebildet ist, also keine Versorgungsspannung über die vier Adern empfangen darf, so würde in diesem Fall ein Datenkabel benutzt werden, welches nur 4 elektrische Kontaktstifte für die vier Adern aufweist. Dann würde in diesem Fall im gesteckten Zustand keine elektrische Verbindung zwischen dem Referenzkontakt 513 und dem elektrischen Kontakt des fünften Kontaktkelchs 523 gebildet werden. Somit fließt kein elektrischer Strom. Somit misst die Messeinrichtung 513 keinen elektrischen Strom. Dies bedeutet für die Messeinrichtung 205, dass sie die Schalter 511 nicht schließen darf.

Nach einer nicht gezeigten Ausführungsform ist das Eingabe-/Ausgabemodul, welches in Figur 1 gezeigt ist, auch für sich, also losgelöst vom Bussystem 1 offenbart. Gleiches gilt für das Datenkabel 4 umfassend den elektrischen Widerstand 525.

In einer weiteren nicht gezeigten Ausführungsform ist vorgesehen, dass das Einspeisemodul 2 analog zum Eingabe-/Ausgabemodul 3 eine Messeinrichtung und zwei Schalteinrichtungen umfasst. Diese Schalteinrichtungen umfassen zum Beispiel analog jeweils zwei Schalter, die in den Leitungsabschnitten 2201, 2202, 2203, 2204 geschaltet sind. Vorzugsweise ist nach einer Ausführungsform vorgesehen, dass das Datenkabel 4, welches das Einspeisemodul 2 und das Eingabe-/Ausgabemodul 3 verbindet, analog zum Datenkabel 4 ausgebildet ist, welches an der Kontaktstelle 37 des Eingabe-/Ausgabemoduls 3 angeschlossen ist.

Somit ist das Verbrauchermodul 3 als ein Eingabe-/Ausgabemodul für ein Bussystem 1 ausgebildet, umfassend eine erste Gleichspannungsversorgung, die Sensor- und Steuerungsversorgung 34, und eine zweite Spannungsversorgung, die Aktorversorgung 35. Das Eingabe-/Ausgabemodul 3 umfasst ferner eine physikalische Schnittstelle 391, einen ersten Übertrager 392, einen zweiten Übertrager 393, erste und zweite induktive Baugruppen, die Induktivitäten 385.

Des Weiteren umfasst das Eingabe-/Ausgabemodul 3 eine erste Schalteinrichtung 507 und eine zweite Schalteinrichtung 509.

Das Eingabe-/Ausgabemodul 3 umfasst des Weitern eine Buchse, die als Buchse ausgebildete Kontaktstelle 37. Die Buchse 37 umfasst fünf Kontaktkelche, die jeweils einen elektrischen Kontakt 515, 517, 519, 521, 523 umfassen. Die beiden Gleichspannungsversorgungen sind über die beiden Schalteinrichtungen 509, 507 respektive mit entsprechenden elektrischen Kontakten der fünf Kontaktkelche elektrisch verbindbar.

Die Figuren 1a und 1b zeigen für eine bessere Übersicht jeweils einen Ausschnitt aus der in Figur 1 gezeigten Anordnung.

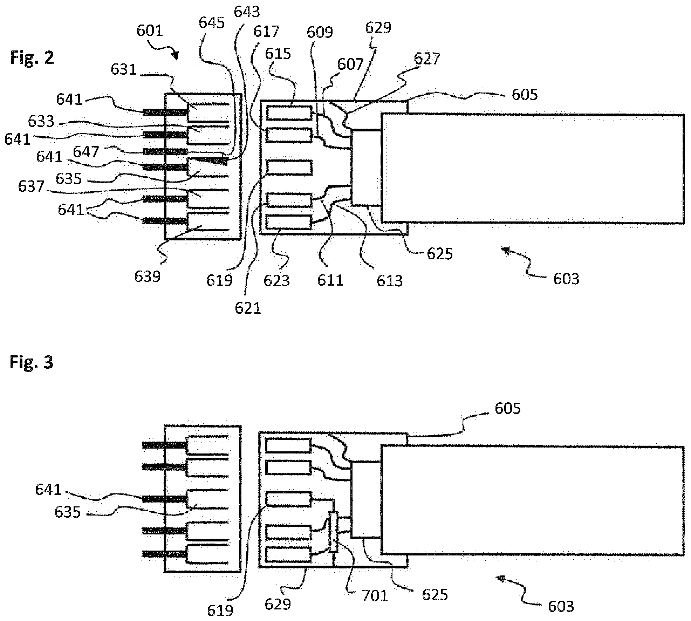

Figur 2 zeigt eine Stecker-Buchse-Anordnung in einer vereinfachten seitlichen Ansicht.

Die in Figur 2 gezeigte Anordnung umfasst eine Buchse 601 und einen Stecker 605 eines Datenkabels 603. Das Datenkabel 603 umfasst vier Adern 607, 609, 611, 613. Die beiden Adern 607, 611 bilden ein erstes Adernpaar. Die Adern 609, 613 bilden ein zweites Adernpaar. Das erste Adernpaar kann einen ersten Kanal bilden, das zweite Adernpaar kann einen zweiten Kanal bilden, um respektive erste und zweite differenzielle Datensignale zu übertragen.

Der Stecker 605 umfasst fünf elektrische Kontaktstifte 615, 617, 619, 621, 623. Die Ader 607 ist mit dem elektrischen Kontaktstift 615 verbunden. Die Ader 609 ist mit dem elektrischen Kontaktstift 617 verbunden. Die Ader 611 ist mit dem elektrischen Kontaktstift 621 verbunden. Die Ader 613 ist mit dem elektrischen Kontaktstift 623 verbunden.

Das heißt also, dass an dem fünften Kontaktstift 619 keine Ader angeschlossen ist.

Bei dem Datenkabel 603 handelt es sich um ein geschirmtes Datenkabel, so dass das Datenkabel 603 insofern eine Schirmung 625 umfasst, die über eine elektrische Verbindung 627 mit einem Außengehäuse 629 des Steckers 605 elektrisch verbunden ist. Das heißt also, wenn das Außengehäuse 629 auf Masse gelegt wird, dass dann auch die Schirmung 625 auf Masse gelegt wird.

Obwohl es zeichnerisch den Anschein haben könnte, dass die vier Adern 607, 609, 611, 613 ebenfalls mit der Schirmung 625 verbunden sind, so verlaufen diese innerhalb der Schirmung 625, sind also nicht mit dieser elektrisch verbunden.

Die Buchse 601 umfasst fünf Kontaktkelche 631, 633, 635, 637, 639, die ausgebildet sind, die fünf Kontaktstifte 615, 617, 619, 621, 623 aufzunehmen. Jeder der fünf Kontaktkelche 631, 633, 635, 637, 639 umfasst einen elektrischen Kontakt 641. Somit kontaktieren die elektrischen Kontaktstifte 615, 617, 619, 621, 623 im gesteckten Zustand die Kontakte 641.

Die Kontakte 641 der beiden Kontaktkelche 637, 639 sind analog zu der in Figur 1 gezeigten Anordnung mit einer Aktorversorgung respektive mit einer physikalischen Schnittstelle über entsprechende Leitungsabschnitte verbunden. Dies ist hier der Übersicht halber nicht gezeigt.

Die Kontakte 641 der beiden Kontaktkelche 631, 633 sind ebenfalls analog zu der in Figur 1 gezeigten Anordnung mit einer Sensor-/Steuerversorgung und der physikalischen Schnittstelle über entsprechende Leitungsabschnitte verbunden. Auch dies ist der Übersicht halber nicht gezeigt.

Die Anordnung der Kontaktkelche und der elektrischen Kontaktstifte ist derart, dass im gesteckten Zustand die elektrischen Kontaktstifte 615, 617 in den Kontaktkelchen 631, 633 aufgenommen sind. Die elektrischen Kontaktstifte 621, 623 sind in den Kontaktkelchen 637, 639 aufgenommen.

Der Kontaktstift 619 ist im Kontaktkelch 635 aufgenommen. Der Kontaktkelch 635 umfasst einen elastischen Kontaktkelchabschnitt 643, der durch das Einstecken des Kontaktstifts 619 aus seiner Ruhelage ausgelenkt wird. Diese Auslenkung ist bezogen auf die Papierebene der Figur 2 nach oben. Oberhalb des Kontaktkelchabschnitts 643 ist ein Schaltkontakt 645 vorgesehen, der über einen elektrischen Kontakt 647 kontaktiert wird. Wenn aufgrund des Einsteckens des Kontaktstifts 619 in den Kontaktkelch 635 sich der Kontaktkelchabschnitt 643 nach oben in Richtung Schaltkontakt 645 bewegt, so wird der Kontaktkelchabschnitt 643 diesen dann kontaktieren. Da der Kontaktkelchabschnitt 643 elektrisch leitend ausgebildet ist und in elektrischer Verbindung mit dem Kontakt 641 steht, fließt ein elektrischer Strom, wenn eine elektrische Spannung an die Kontakte 647, 641 angelegt ist, was nach einer Ausführungsform so vorgesehen ist. Dieser elektrische Strom kann gemessen werden und ist ein Zeichen dafür, dass das Datenkabel 603 einen fünften Kontaktstift umfasst. Insofern können die Schalteinrichtungen des Eingabe-/Ausgabemoduls geschlossen werden. Dies geschieht analog zu den im Zusammenhang mit der Figur 1 gemachten Ausführungen.

Sofern ein Datenkabel verwendet wird, welches keinen fünften Kontaktstift 619 umfasst, so wird der Schaltkontakt 645 nicht mittels des Kontaktkelchabschnitts 643 betätigt. In diesem Fall fließt kein elektrischer Strom bei Anlegen einer Spannung. Dies ist ein Zeichen dafür, dass die Schalteinrichtungen geöffnet bleiben müssen und nicht geschlossen werden dürfen.

Figur 3 zeigt eine weitere Stecker-Buchse-Anordnung.

Die in Figur 3 gezeigte Anordnung ist im Wesentlichen analog zu der in Figur 2 gezeigten Anordnung aufgebaut. Entsprechend wird auf die diesbezüglichen Ausführungen verwiesen. Als ein Unterschied ist kein Schaltkontakt 645 umfassend einen elektrischen Kontakt 647 vorgesehen. Insbesondere umfasst der Kontaktkelch 635 keinen elastischen elektrisch leitenden Kontaktkelchabschnitt 643. Vielmehr ist in Figur 3 vorgesehen, dass der Stecker 605 der in Figur 3 gezeigten Anordnung einen elektrischen Widerstand 701 umfasst, der den elektrischen Kontaktstift 619 mit dem Außengehäuse 629, also somit mit der Schirmung 625, verbindet.

Im gesteckten Zustand wird somit eine elektrische Verbindung zwischen dem elektrischen Kontakt 641 des Kontaktkelchs 635 und dem elektrischen Referenzkontakt gebildet, denn im gesteckten Zustand kontaktiert die Schirmung des Datenkabels 603 den elektrischen Referenzkontakt, allgemein die Masse. Wenn nun eine Spannung angelegt wird, so fließt dann auch hier analog zu Figur 2 ein elektrischer Strom, der gemessen werden kann. Dies ist ein Zeichen dafür, die Schalteinrichtungen zu schließen. Sofern kein fünfter Kontaktstift 619 vorgesehen ist, so fließt bei Anlegen einer elektrischen Spannung kein Strom. Dies ist ein Zeichen dafür, die Schalteinrichtungen geöffnet zu lassen respektive nicht zu schließen.

Der Stromverlauf, der gemessen wird, hängt insbesondere von der Art oder dem Typ des verwendeten elektrischen Bauelements ab, welches die Masse oder die Schirmung des Datenkabels 603 mit dem fünften elektrischen Kontaktstift 619 verbindet. Sofern zum Beispiel ein Kondensator anstelle des elektrischen Widerstands 701 vorgesehen ist, würde ein anderer Stromverlauf gemessen werden. Sofern zum Beispiel eine Spule anstelle des Widerstands 701 vorgesehen ist, so würde ein anderer elektrischer Stromverlauf gemessen werden. Somit kann also basierend auf einem gemessenen Stromverlauf bestimmt werden, um welches elektrisches Bauelement es sich handelt. Insbesondere können über den gemessenen Stromverlauf Eigenschaften der verwendeten elektrischen Bauelemente bestimmt werden. Solche Eigenschaften sind zum Beispiel ein Induktivitätswert bei einer Induktivität, ein Kapazitätswert bei einem Kondensator oder ein Widerstandswert bei einem Widerstand.

Es ist zum Beispiel vorgesehen, dass unterschiedliche elektrische Eigenschaften der verwendeten elektrischen Bauelemente eine Datenkabellänge codieren. Insbesondere können diese Eigenschaften Betriebsparameter des Eingabe-/Ausgabemoduls codieren.

Bei den in den Figuren 2 und 3 gezeigten Steckern kann also in vorteilhafter Weise erkannt werden, welches Datenkabel gesteckt ist, so dass entschieden werden kann, ob eine Versorgungsspannung an den entfernten Teilnehmer weitergeleitet werden soll oder nicht.

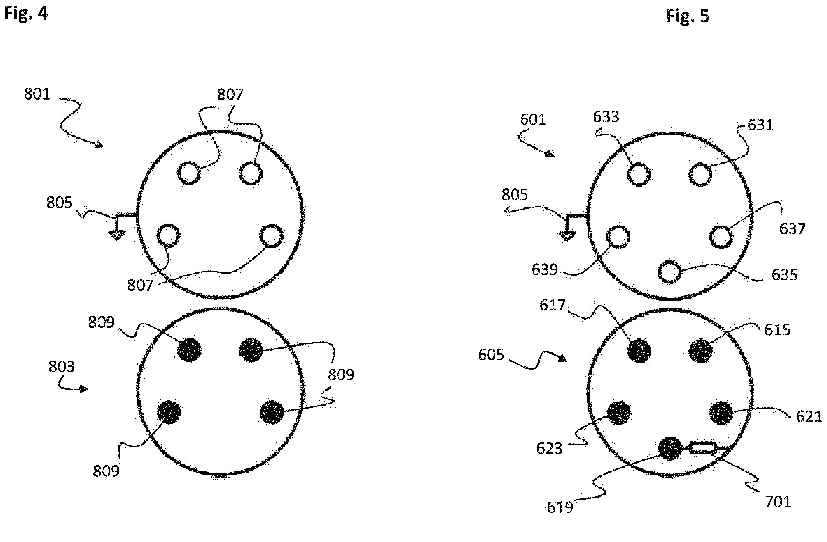

Figur 4 zeigt eine andere Stecker-Buchse-Anordnung in einer vereinfachten Schnittansicht.

Figur 4 zeigt eine Buchse 801 umfassend vier Kontaktkelche 807. Die Buchse 801 ist mit ihrem Gehäuse auf Masse 805, allgemein auf einen elektrischen Referenzkontakt, gelegt. Die elektrischen Kontakte der Kontaktkelche 807 sind der Übersicht halber nicht gezeigt.

Ein der Buchse 801 komplementärer Stecker 803 umfasst insofern vier elektrische Kontaktstifte 809.

Figur 5 zeigt die in Figur 3 gezeigte Buchse-Stecker-Anordnung in einer vereinfachten weiteren Ansicht von vorne. Die jeweilige Anordnung der Kontaktkelche und der Kontaktstifte zueinander ist derart, dass die Kontaktkelche die Kontaktstifte aufnehmen können. Ferner ist die Anordnung der Kontaktkelche derart, dass diese die Kontaktstifte 809 des Steckers 803 der Figur 4 aufnehmen können.

Das heißt also, dass der Stecker 803 der Figur 4 in die Buchse 601 der Figur 5 passt. Allerdings wird aufgrund des Fehlens des fünften Kontaktstifts und des Fehlens des elektrischen Widerstands 701 bei Anlegen einer entsprechenden Messspannung kein elektrischer Strom gemessen werden. Somit kann detektiert werden, dass es sich bei dem in die Buchse 601 gesteckten Stecker um einen Stecker mit vier Kontaktstiften handelt und nicht um einen Stecker mit fünf Kontaktstiften. Dies ist dann ein Zeichen dafür, dass die Versorgungsspannung nicht dem entfernten an das Datenkabel angeschlossenen Teilnehmer zur Verfügung gestellt werden darf. Der Stecker 605 gemäß der in Figur 5 gezeigten Anordnung kann aufgrund des fünften Kontaktstifts 619 nicht in die Buchse 801 gemäß Figur 4 gesteckt werden. Sofern also ein Stecker umfassend fünf Kontaktstifte als der neue Stecker bezeichnet wird und insofern die Buchse umfassend fünf Kontaktkelche als die neue Buchse bezeichnet wird und wenn insofern ein Stecker umfassend nur vier Kontaktstifte als der alte Stecker bezeichnet wird und wenn insofern eine Buchse umfassend nur vier Kontaktkelche als die alte Buchse bezeichnet wird, so passt der alte Stecker in die neue Buchse. Der neue Stecker passt aber nicht in die alte Buchse, sondern nur in die neue Buchse.

Das Messverfahren, das dazu verwendet wird, um zu entscheiden, ob dem entfernten Teilnehmer die Versorgungsspannung zur Verfügung gestellt werden darf oder nicht, ist insbesondere auf das elektrische Bauelement abzustimmen, welches den fünften Kontaktstift mit der Schirmung verbindet.

Wenn nach einer Ausführungsform ein elektrischer Widerstand vorgesehen ist, so ist insbesondere vorgesehen, dass eine entsprechende Messspannung angelegt und der daraus resultierende Strom gemessen wird. Der Strom wird nach einer Ausführungsform mittels eines einzelnen Transistors gemessen, der bei einem vorhandenen elektrischen Widerstand durchschaltet und so den gemessenen Strom zu einem Schaltsignal für die Schalteinrichtungen verstärkt. Zum Beispiel ist vorgesehen, dass verschiedene Werte für den elektrischen Widerstand, also Widerstandswerte, mittels eines ADC erkannt werden, so dass hierüber in vorteilhafter Weise weitere Informationen wie zum Beispiel eine Leitungslänge codiert werden können. Der Widerstand ist nach einer Ausführungsform als eine Leiterbrücke ausgebildet. Die Abkürzung "ADC" steht für "Analog-to-Digital-Converter". Übersetzt werden kann dies mit "Analog-Digital-Wandler" oder einfach nur "A/D-Wandler".

Wenn nach einer Ausführungsform als elektrisches Bauelement ein komplexer Wechselstromwiderstand in Form einer Induktivität L oder einer Kapazität C vorgesehen ist, so können zum Beispiel die folgenden zwei Messverfahren verwendet werden.

Nach einer ersten Ausführungsform ist vorgesehen, dass eine Gleichspannung aufgeschaltet und der dynamische Stromfluss im Einschaltmoment über den ADC gemessen oder beobachtet wird, so dass über den Stromverlauf das elektrische Bauelement als Induktivität L oder als Kapazität C identifiziert werden kann. Je nach Genauigkeit des eingesetzten ADCs können auch verschiedene Werte für L oder C bestimmt werden, so dass auch hier weitere Informationen codiert werden können.

Nach einer zweiten Ausführungsform wird eine definierte Wechselspannung aufgeschaltet und der dynamische Stromverlauf durch das elektrische Bauelement gemessen. Durch das Bestimmen der Phasenverschiebung von Strom und Spannung durch das Bauelement können R, L und C identifiziert werden.

Wenn in einer anderen Ausführungsform aktive Zweipole, wie zum Beispiel Dioden, als elektrische Bauelemente verwendet werden, so ist insbesondere nach einer Ausführungsform ein Aufschalten einer Wechselspannung und ein Messen oder Beobachten des daraus resultierenden Stromflusses vorgesehen, um den fünften Kontaktstift detektieren zu können.

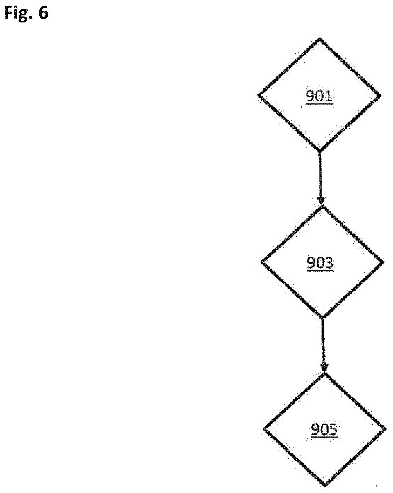

Figur 6 zeigt ein Ablaufdiagramm eines Verfahrens zum Betreiben eines Eingabe-/Ausgabemoduls. Bei dem Eingabe-/Ausgabemodul handelt es sich zum Beispiel um das Eingabe-/Ausgabemodul 3 gemäß Figur 1.

Das Verfahren umfasst die folgenden Schritte:

- Detektieren (901) mittels der Messeinrichtung bei einem in die Buchse eingesteckten Stecker, ob der Stecker vier oder fünf elektrische Kontaktstifte umfasst, die jeweils in einem der Kontaktkelche gesteckt und mit dem jeweiligen elektrischen Kontakt der Kontaktkelche elektrisch verbunden sind,

- Schließen (903) der beiden Schalteinrichtungen mittels der Messeinrichtung ausschließlich bei einer Detektion von fünf elektrischen Kontaktstiften, so dass aufgrund der geschlossenen Schalteinrichtungen eine jeweilige Versorgungsspannung der beiden Gleichspannungsversorgungen an die entsprechenden gesteckten Kontaktstifte des in der Buchse gesteckten Steckers über die jeweiligen elektrischen Kontakte der Kontaktkelche angelegt wird (905).

In der Automatisierungstechnik haben sich verschiedene Feldbusprotokolle auf Ethernet mit einer Datenrate von 100 MBit/s etabliert. Da sich im Verbraucherbereich inzwischen Ethernet mit einer Datenrate von 1 GBit/s durchgesetzt hat, ist es sinnvoll, auch Feldbusprotokolle mit einer Datenrate von 1 GBit/s oder von 10 GBit/s zu übertragen.

Im Gegensatz zum Verbraucherbereich, in welchem wenige Teilnehmer große Datenmengen übertragen, müssen in der Feldbustechnik viele Teilnehmer mit wenigen Daten miteinander kommunizieren. Die Laufzeit eines Ethernettelegramms bei Standard-GBit-Technik zwischen zwei Teilnehmern beträgt etwa 1 $\mu$s, was der Übertragungszeit von 1000 Bit entspricht.

Aufgrund der größeren Anzahl der Teilnehmer in der Feldbustechnik, die in der Regel in Linie miteinander verbunden sind, spielt die Laufzeit eines Telegramms vom Sender zum Empfänger eine wesentlich größere Rolle.

Eine Standard Ethernet-Anschaltung mit Gigabit-Physik (1000-BASE-T) zeigt schematisch in einer vereinfachten Ansicht das Blockdiagramm gemäß Figur 7.

Die Anschaltung umfasst eine physikalische Schnittstelle (auch PHY genannt) 1001 sowie eine Sender- und Empfangseinheit 1003. Als Kontaktstelle, zum Beispiel als ein Stecker, wird zum Beispiel ein RJ45-Stecker 1005 verwendet.

Als Schnittstelle zwischen der physikalischen Schnittstelle 1001 und der Sender- und Empfangseinheit 1003 wird üblicherweise das sogenannte "Reduced Gigabit Media Independent Interface (RGMII)" verwendet. Diese Schnittstelle wird im Folgenden einfach nur als RGMII bezeichnet. Beim RGMII werden vier Bits parallel mit 250 MBit/s übertragen. Die Schnittstelle zwischen der physikalischen Schnittstelle 1001 und einem Trafo 1007, der zwischen dem RJ45-Stecker 1005 und der physikalischen Schnittstelle 1001 geschaltet ist, bzw. die Schnittstelle auf dem Kabel ist ein Signal, bei dem nach dem PAM-5-Verfahren (PAM: Pulsamplitudenmodulation) über vier Doppeladern jeweils fünf Spannungspegel mit 125 MBit/s übertragen werden. Dadurch ergibt sich eine Symbolmenge von $5^4$=625 (5 hoch 4 = 625), die mit 125 MBit/s (der Übertragungsrate von einem Byte (256 Symbole)) übertragen wird. Da ein Byte nur 256 Symbole umfasst, werden die restlichen Symbole für eine Fehlerkorrektur verwendet, wodurch Übertragungsstrecken von bis zu 100 m zwischen zwei Teilnehmern erreicht werden.

Im Vollduplexbetrieb werden die Doppeladern bidirektional verwendet, wobei der Empfänger sein Sendesignal abzieht, um das Empfangssignal zu erhalten.

Der größte Anteil der Durchlaufzeit entsteht durch die physikalisch Schnittstelle 1001, die die vier Bits der RGMII-Schnittstelle in die Symbole des PAM-5-Verfahrens umsetzt.

Das PAM-5-Verfahren wird also verwendet, um Signale bzw. Daten zwischen dem RJ45-Stecker 1005 und dem Trafo 1007 respektive zwischen dem Trafo 1007 und der PHY 1001 zu übertragen.

In der Feldbustechnik ist es so, dass hier bei vielen Anwendungen eine kürzere Übertragungsstrecke zwischen zwei Teilnehmern, also zum Beispiel zwischen zwei Eingabe-/Ausgabemodulen, ausreicht, wodurch ein einfacheres Übertragungsverfahren verwendet werden kann, bei dem das zu übertragende Signal direkt von der Sender- und Empfangseinheit 1003 erzeugt wird, so dass keine physikalische Schnittstelle benötigt wird. Dadurch kann in vorteilhafter Weise eine Durchlaufzeit wesentlich verkürzt werden.

Um nicht Geräte, also insbesondere Eingabe-/Ausgabemodule, mit zwei unterschiedlichen Schnittstellen herstellen oder entwickeln zu müssen, ist erfindungsgemäß vorgesehen, dass eine physikalische Anschaltung einen Schalter umfasst, mittels welchem die physikalische Schnittstelle überbrückt werden kann. Dadurch kann in vorteilhafter Weise dieselbe physikalische Anschaltung sowohl für Standard-GBit-Physik als auch für eine einfachere Übertragungstechnik mit kürzerer Reichweite verwendet werden.

Eine solche zweite physikalische Anschaltung wird realisiert, um Teilnehmer, die ein gleiches Spannungspotential besitzen, über eine einfache Kontakt- bzw. Steckverbindung mit möglichst wenig Kontakten zu verbinden. Bei dieser Anschaltung werden die Signale bitweise nur über zwei Anschlüsse je Richtung übertragen werden. Dafür werden nur noch Sender und Empfänger benötigt, was einerseits die Hardwarekosten und andererseits die Durchlaufzeit reduziert.

Die umschaltbare physikalische Anschaltung ist zum Beispiel gemäß dem in der Figur 8 gezeigten Blockdiagramm realisiert.

Es ist vorgesehen, dass zwischen dem Trafo 1007 und der physikalischen Schnittstelle 1001 ein Schalter 1101 vorgesehen ist, der zum Beispiel als ein Hochfrequenzschalter ausgebildet ist. Ferner ist von diesem Schalter 1101 eine Leitung gebildet, die den Schalter 1101 mit der Sender- und Empfangseinheit 1003 verbindet. Der Schalter 1101 weist zwei Schaltzustände auf. In dem ersten Schaltzustand verbindet der Schalter 1101 den Trafo 1007 mit der physikalischen Schnittstelle 1001. Im zweiten Schaltzustand verbindet der Schalter 1101 den Trafo 1007 direkt mit der Sender- und Empfangseinheit 1003. Das heißt also, dass in der in Figur 8 gezeigten physikalischen Anschaltung ein Schalter 1101 integriert ist, mit dem die Leitungen zum Trafo 1007 entweder zur physikalischen Schnittstelle 1001 oder direkt zur Sender- und Empfangseinheit 1003 geschaltet werden kann. Mittels des Schalters 1101 kann somit in vorteilhafter Weise die PHY 1001 überbrückt werden.

Ein Datenübertragungsverfahren zwischen dem Schalter 1101 und der Sender- und Empfangseinheit 1003 kann zum Beispiel mittels der "Special Transfer Method (STM)" durchgeführt werden.

Bei einer Verbindung zwischen zwei Teilnehmern, also zum Beispiel zwischen zwei Eingabe-/Ausgabemodulen, gibt es die folgenden Möglichkeiten:

1. Ein Teilnehmer unterstützt nur Standard-GBit-Übertragung
2. Beide Teilnehmer unterstützen beide Übertragungsverfahren, die Leitungslänge zwischen beiden Teilnehmern ist aber zu groß für das einfache Übertragungsverfahren
3. Beide Teilnehmer unterstützen beide Übertragungsverfahren, die Leitungslänge zwischen beiden Teilnehmern ist klein genug für das einfache Übertragungsverfahren

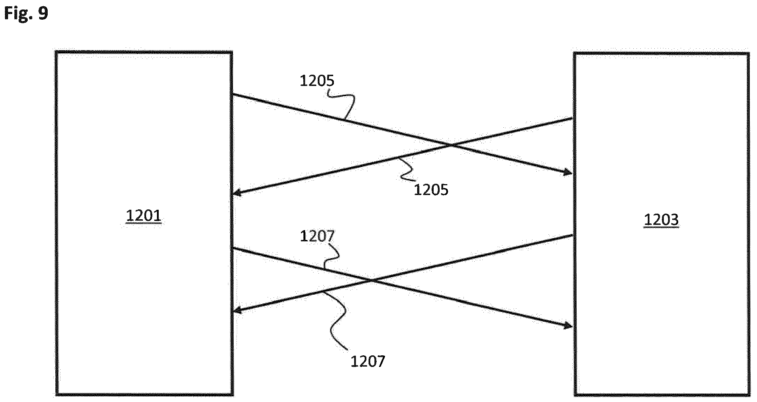

Daher ist nach einer Ausführungsform vorgesehen, dass zunächst eine Standard-GBit-Verbindung zwischen beiden Teilnehmern aufgebaut wird. Anschließend ist dem jeweils anderen Teilnehmer mitzuteilen, dass eine umschaltbare physikalische Anschaltung vorhanden ist. Wenn beide Teilnehmer die umschaltbare physikalische Anschaltung besitzen, ist noch die Entfernung zwischen beiden Teilnehmern über eine Laufzeitmessung festzustellen. Zum Beispiel kann die Laufzeit ähnlich des IEEE 1588-Verfahrens ermittelt werden. Eine Ausführungsform, um eine Laufzeitmessung durchzuführen, zeigt beispielhaft das Blockdiagramm gemäß Figur 9.

Gezeigt sind zwei Teilnehmer 1201, 1203, die zum Beispiel als ein Eingabe-/Ausgabemodul ausgebildet sein können.

Zum Zeitpunkt t1_1 sendet der Teilnehmer 1201 ein erstes Telegramm 1205 an den Teilnehmer 1203. Das Telegramm 1205 kann zum Beispiel ein SimplePhysicReq-Telegramm sein. Hierbei speichert der Teilnehmer 1201 den Sendezeitpunkt t1_1 des Telegramms 1205.

Wenn der Teilnehmer 1203 das Telegramm 1205 empfängt, speichert der Teilnehmer 1203 den Empfangszeitpunkt t2_1 des Telegramms 1205. Der Teilnehmer 1203 schickt zum Zeitpunkt t3_1 ein weiteres Telegramm 1207, das zum Beispiel als ein SimplePhysicRes-Telegramm ausgebildet ist, zurück zum Teilnehmer 1201. Dieses Telegramm 1207 umfasst die Zeitpunkte t2_1 und t3_1.

Der Teilnehmer 1201 empfängt das Telegramm 1207 und speichert den Empfangszeitpunkt t4_1 des Telegramms 1207.

Analog wird das vorstehend beschriebene Verfahren beginnend mit dem Teilnehmer 1203 durchgeführt: Der Teilnehmer 1203 sendet analog zu einem Zeitpunkt t1_2 ein Telegramm 1205, zum Beispiel ein SimplePhysicReq-Telegramm, an den Teilnehmer 1201 und speichert den Sendezeitpunkt t1_2 des Telegramms 1205. Wenn der Teilnehmer 1201 das Telegramm 1205 empfängt, speichert der Teilnehmer 1201 den Empfangszeitpunkt t2_2 des Telegramms 1205. Der Teilnehmer 1201 schickt zum Zeitpunkt t3_2 ein weiteres Telegramm 1207, das zum Beispiel als ein SimplePhysicRes-Telegramm ausgebildet ist, zurück zum Teilnehmer 1203. Dieses Telegramm 1207 umfasst die Zeitpunkte t2_2 und t3_2. Der Teilnehmer 1203 empfängt das Telegramm 1207 und speichert den Empfangszeitpunkt t4_2 des Telegramms 1207.

Beide Teilnehmer 1201, 1203 verfügen nun jeweils über vier Zeiten t1_1 bis t4_1 respektive t1_2 bis t4_2.

Der Teilnehmer 1201 berechnet die Laufzeit wie folgt:

$$\text{Laufzeit} = ((t4\_1 - t1\_1) - (t3\_1 - t2\_1))/2$$

Der Teilnehmer 1203 berechnet die Laufzeit wie folgt:

$$\text{Laufzeit} = ((t4\_2 - t1\_2) - (t3\_2 - t2\_2))/2$$

Beide Teilnehmer 1201, 1203 ermitteln oder berechnen basierend auf ihrer jeweiligen ermittelten Laufzeit eine Entfernung zwischen sich und dem anderen Teilnehmer.

Ist die berechnete Entfernung unterhalb einer erlaubten Entfernung für das einfache Übertragen, ist nach einer Ausführungsform vorgesehen, dass sich die Teilnehmer 1201, 1203 hierüber verständigen. Beide Teilnehmer 1201, 1203 schalten insofern dann auf das einfache Übertragungsverfahren um. Denn beide Teilnehmer 1201, 1203 umfassen eine umschaltbare Anschaltung gemäß dem Blockdiagramm der Figur 8. Sofern die Entfernung oberhalb einer der erlaubten Entfernung für das einfache Übertragen ist, so wird nicht umgeschaltet.

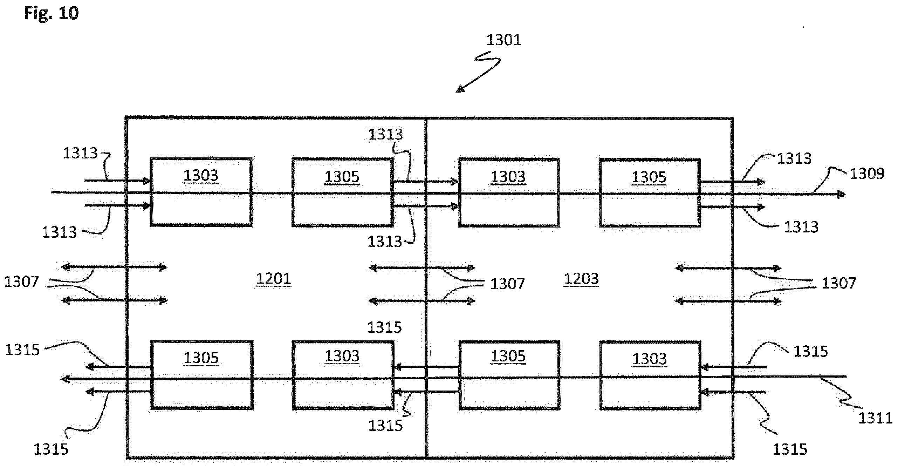

Figur 10 zeigt ein Blockdiagramm eines GBus 1301.

Der GBus ist eine steckbare physikalische Verbindung mit zwei Teilnehmern, die zum Beispiel als Eingabe-/Ausgabemodul ausgebildet sein können, mit sechs Leitungen, zum Beispiel sechs Adern, wovon je Übertragungsrichtung ein Leitungspaar (Adernpaar) und noch ein drittes Leitungspaar (drittes Adernpaar) für eine Spannungsübertragung verwendet wird.

Der GBus 1301 gemäß dem Blockdiagramm der Figur 10 ist wie folgt aufgebaut:

Zwei Teilnehmer 1201, 1203 sind über zwei Adernpaare umfassend zwei Adern 1315 respektive zwei Adern 1313 miteinander verbunden. Ein drittes Adernpaar umfassend zwei Adern 1307 ist symbolisch mittels Doppelpfeilen dargestellt und verbindet ebenfalls die beiden Teilnehmer 1201, 1203 und wird für eine Spannungsversorgung verwendet.

Eine erste Übertragungsrichtung vom Teilnehmer 1201 zum Teilnehmer 1203 ist mit einem Pfeil mit dem Bezugszeichen 1309 symbolisch dargestellt. Die dieser Übertragungsrichtung 1309 entgegengesetzte Übertragungsrichtung 1311 vom Teilnehmer 1203 zum Teilnehmer 1201 ist symbolisch mit einem Pfeil mit dem entsprechenden Bezugszeichen 1311 dargestellt. Die Adern für eine Datenübertragung entsprechend der Übertragungsrichtung 1309 sind symbolisch mit Pfeilen mit den Bezugszeichen 1313 dargestellt. Adern des Adernpaares zur Datenübertragung entsprechend der Übertragungsrichtung 1311 sind symbolisch mittels Pfeilen mit den Bezugszeichen 1315 dargestellt.

Je Übertragungsrichtung 1309, 1311 umfassen die Teilnehmer 1201, 1203 Sender 1305 und Empfänger 1303. Eine Signalübertragung erfolgt bitweise entsprechend des SerDes-Verfahrens (SerDes: Serialisierer/Deserialisiere), wobei 8 Bit als 10 Bits codiert mit 1,25 GHz übertragen werden.

Da beim GBus 1301 keine Kabel, Trafos oder physikalische Schnittstellen zwischen Sender 1305 und Empfänger 1303 mehr benötigt werden, ist diese Anschaltung besonders kostengünstig und weist eine minimale Durchlaufzeit auf.

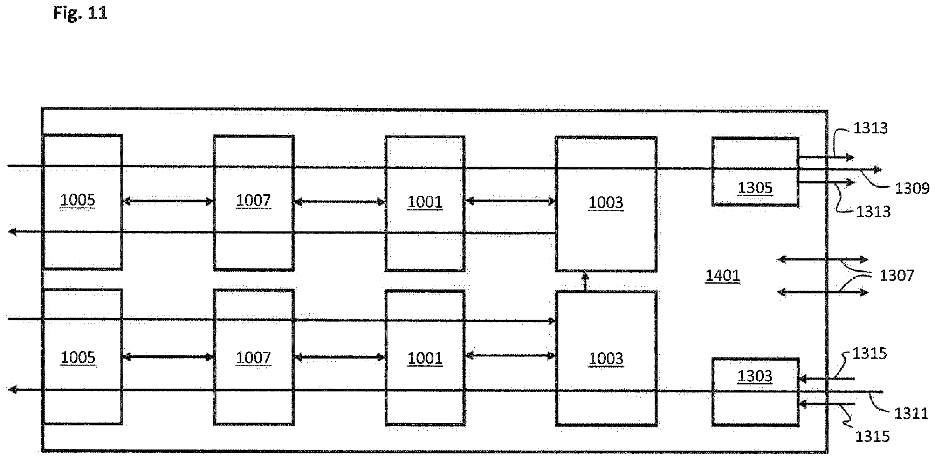

Figur 11 zeigt beispielhaft vereinfacht ein Blockdiagramm eines GBus-Wandlers 1401.

Um Teilnehmer mit einer GBus-Verbindung auch an Standard-GBit-Teilnehmer anschließen zu können, ist ein Umwandler 1401 gemäß Figur 11 vorgesehen, der entweder eine umschaltbare physikalische Verbindung oder die Standard-GBit-Verbindung auf GBus umsetzt. Gemäß Figur 11 umfasst der Wandler 1401 zwei Standard-GBit- und eine GBus-Verbindung. Die in Figur 11 dargestellten Pfeile sollen symbolisch eine Datenübertragungsrichtung symbolisieren respektive eine Spannungsübertragungsrichtung (bei den Doppelpfeilen 1307).

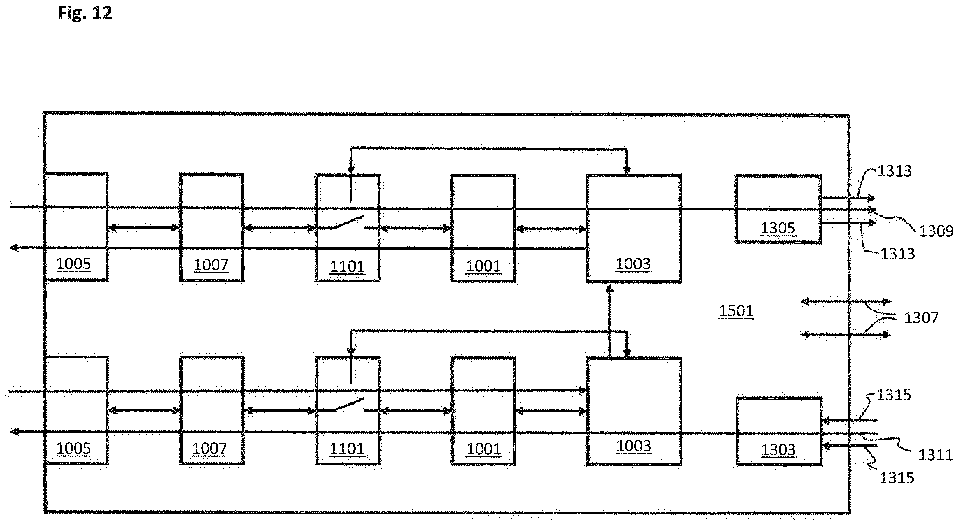

In Figur 12 ist ein umschaltbarer GBus-Wandler 1501 gezeigt, der zwei Schalter 1101 analog zu Figur 8 umfasst, um die physikalische Schnittstelle 1001 zu überbrücken. Die in Figur 12 dargestellten Pfeile sollen symbolisch eine Datenübertragungsrichtung symbolisieren respektive eine Spannungsübertragungsrichtung (bei den Doppelpfeilen 1307).

Somit ist vorgesehen, dass für kürzere Entfernungen andere physikalische Schnittstellen verwendet werden, um zum Beispiel EtherCAT mit 1 GBit/s, insbesondere 10 GBit/s, mit einer geringen Laufzeit übertragen zu können. Ferner ist nach einer Ausführungsform eine umschaltbare Verbindung (gebildet durch den Schalter 1101) vorgesehen, die entsprechend der verbundenen Teilnehmer zwischen einer schnelleren physikalischen Übertragung bei geringerer Reichweite und einer Standard-Ethernet-GBit (10 GBit/s oder mehr) umschalten kann.

Der im Zusammenhang mit den vorstehend gemachten Ausführungen beschriebene Schalter 1101 ist zum Beispiel beim Eingabe-/Ausgabemodul 3 der Fig. 1 vorgesehen, um dort entsprechend den Blockdiagrammen der Fig. 8 und 12 die physikalische Schnittstelle 391 zu überbrücken.

**Patentansprüche**

**1.** Eingabe-/Ausgabemodul (3) für ein Bussystem (1), umfassend:

- eine erste Gleichspannungsversorgung (34) und eine zweite Gleichspannungsversorgung (35),
- eine physikalische Schnittstelle (391), einen ersten Übertrager (392), einen zweiten Übertrager (393), eine erste induktive Baugruppe (385), eine zweite induktive Baugruppe (385), eine erste kapazitive Baugruppe (386), eine zweite kapazitive Baugruppe (386), eine erste Schalteinrichtung (507) und eine zweite Schalteinrichtung (509),
- eine fünf Kontaktkelche aufweisende Buchse (37),
- wobei die fünf Kontaktkelche jeweils einen elektrischen Kontakt (641) umfassen,
- wobei die erste Gleichspannungsversorgung (34) über die erste induktive Baugruppe (385) mittels der ersten Schalteinrichtung (507) mit einem jeweiligen elektrischen Kontakt (641) von zwei der fünf Kontaktkelche elektrisch verbindbar ist,

- wobei die zweite Gleichspannungsversorgung (35) über die zweite induktive Baugruppe (385) mittels der zweiten Schalteinrichtung (509) mit einem jeweiligen elektrischen Kontakt (641) von zwei anderen der fünf Kontaktkelche elektrisch verbindbar ist,

- wobei die physikalische Schnittstelle (391) über den ersten Übertrager (392) und über die erste kapazitive Baugruppe (386) mit den jeweiligen elektrischen Kontakten (641) von zwei der fünf Kontaktkelche elektrisch verbunden ist, um ein erstes differenzielles Datensignal an die zwei elektrischen Kontakte (641) der zwei der fünf Kontaktkelche anzulegen,

- wobei die physikalische Schnittstelle (391) über den zweiten Übertrager (393) und über die zweite kapazitive Baugruppe (386) mit den jeweiligen elektrischen Kontakten (641) von den zwei anderen der fünf Kontaktkelche elektrisch verbunden ist, um ein zweites differenzielles Datensignal an die zwei elektrischen Kontakte (641) der anderen zwei der fünf Kontaktkelche anzulegen, und

- eine Messeinrichtung (205) zur Detektion eines Steckers (605) eines vieradrigen Datenkabels (4), die ausgebildet ist, bei einem in die Buchse (37) eingesteckten Stecker (605) zu detektieren, ob der Stecker (605) vier oder fünf elektrische Kontaktstifte umfasst, die jeweils in einem der Kontaktkelche gesteckt und mit dem jeweiligen elektrischen Kontakt (641) der Kontaktkelche elektrisch verbunden sind,

- wobei die Messeinrichtung (205) ausgebildet ist, ausschließlich bei einer Detektion von fünf elektrischen Kontaktstiften die erste und die zweite Schalteinrichtung (507, 509) zu schließen, um eine jeweilige Versorgungsspannung der beiden Gleichspannungsversorgungen (34, 35) an die entsprechenden gesteckten Kontaktstifte des in der Buchse (37) gesteckten Steckers (605) über die jeweiligen elektrischen Kontakte (641) der Kontaktkelche anzulegen.

2. Eingabe-/Ausgabemodul (3) nach Anspruch 1, wobei die Messeinrichtung (205) ausgebildet ist, eine elektrische Messspannung zwischen dem elektrischen Kontakt (641) des fünften Kontaktkelchs, der verschieden von den zwei und den anderen zwei der fünf Kontaktkelche ist, und einem elektrischen Referenzkontakt (513) anzulegen und einen zwischen dem Referenzkontakt (513) und dem elektrischen Kontakt (641) des fünften Kontaktkelchs fließenden elektrischen Strom zu messen, wobei der elektrische Referenzkontakt (513) von dem elektrischen Kontakt (641) des fünften Kontaktkelchs elektrisch isoliert ist, wobei die Messeinrichtung (205) ausgebildet ist, die beiden Schalteinrichtungen (507, 509) zu schließen, wenn bei angelegter elektrischer Messspannung ein zwischen dem elektrischen Referenzkontakt (513) und dem elektrischen Kontakt (641) des fünften Kontaktkelchs fließender elektrischer Strom gemessen wird.

3. Eingabe-/Ausgabemodul (3) nach Anspruch 2, wobei die Messeinrichtung (205) einen Transistor umfasst, der ausgebildet ist, bei einem zwischen dem elektrischen Referenzkontakt (513) und dem elektrischen Kontakt (641) des fünften Kontaktkelchs fließenden elektrischen Stroms durchzuschalten, wobei die Messeinrichtung (205) ausgebildet ist, ein Durchschalten des Transistors zu detektieren und bei Detektion eines Durchschaltens des Transistors die beiden Schalteinrichtungen (507, 509) zu schließen.

4. Eingabe-/Ausgabemodul (3) nach Anspruch 2 oder 3, wobei die Messeinrichtung (205) ausgebildet ist, basierend auf der angelegten Messspannung und auf dem gemessenen elektrischen Strom zu ermitteln, was für ein im Stecker (605) integriertes elektrisches Bauelement (525) eine elektrische Verbindung zwischen dem elektrischen Referenzkontakt (513) und dem elektrischen Kontakt (641) des fünften Kontaktkelchs gebildet hat, wobei die Messeinrichtung (205) insbesondere ausgebildet ist, eine elektrische Eigenschaft des elektrischen Bauelements (525) zu ermitteln, wobei das elektrischen Bauelements insbesondere das angesteckte Datenkabel (4) ist.

5. Eingabe-/Ausgabemodul (3) nach einem der vorherigen Ansprüche, wobei die Messeinrichtung (205) einen elektrischen Schaltkontakt (645) umfasst und wobei der elektrische Kontakt (641) des fünften Kontaktkelchs, der verschieden von den zwei und den anderen zwei der fünf Kontaktkelche ist, beweglich gelagert ist, so dass bei einem Einstecken eines elektrischen Kontaktstifts des Steckers (605) in den fünften Kontaktkelch der in den fünften Kontaktkelch eingesteckte elektrische Kontaktstift den beweglich gelagerten elektrischen Kontakt (643) bewegt, so dass dieser den elektrischen Schaltkontakt (645) betätigt, wobei die Messeinrichtung (205) ausgebildet ist, bei betätigtem elektrischen Schaltkontakt (645) die beiden Schalteinrichtungen (507, 509) zu schließen.

6. Eingabe-/Ausgabemodul (3) nach einem der vorherigen Ansprüche, wobei die Messeinrichtung (205) ausgebildet ist, über den elektrischen Kontakt (641) des fünften Kontaktkelchs, der verschieden von den zwei und den anderen zwei der fünf Kontaktkelche ist, zu überprüfen, ob im Stecker (605) ein programmierbarer Speicher als elektrisches Bauelement (525) integriert ist, und basierend auf der Überprüfung die beiden Schalteinrichtungen (507, 509) zu schließen.

7. Verfahren zum Betreiben eines Eingabe-/Ausgabemoduls (3) nach einem der vorherigen Ansprüche, umfassend die folgenden Schritte:

- Detektieren (901) mittels der Messeinrichtung (205) bei einem in die Buchse (37) eingesteckten Stecker (605), ob der Stecker (605) vier oder fünf elektrische Kontaktstifte umfasst, die jeweils in einem der Kontaktkelche gesteckt und mit dem jeweiligen elektrischen Kontakt (641) der Kontaktkelche elektrisch verbunden sind,
- Schließen (903) der beiden Schalteinrichtungen (507, 509) mittels der Messeinrichtung (205) ausschließlich bei einer Detektion von fünf elektrischen Kontaktstiften, so dass aufgrund der geschlossenen Schalteinrichtungen (507, 509) eine jeweilige Versorgungsspannung der beiden Gleichspannungsversorgungen (34, 35) an die entsprechenden gesteckten Kontaktstifte des in der Buchse (37) gesteckten Steckers (605) über die jeweiligen elektrischen Kontakte (641) der Kontaktkelche angelegt wird (905).

8. Verfahren nach Anspruch 7 bezüglich des Eingabe-/Ausgabemoduls (3) rückbezogen auf Anspruch 2, umfassend ferner:

- Anlegen mittels der Messeinrichtung (205) einer elektrischen Messspannung zwischen dem elektrischen Kontakt (641) des fünften Kontaktkelchs, der verschieden von den zwei und den anderen zwei der fünf Kontaktkelche ist, und einem elektrischen Referenzkontakt (513) und
- Messen mittels der Messeinrichtung (205), ob zwischen dem Referenzkontakt (513) und dem elektrischen Kontakt (641) des fünften Kontaktkelchs ein elektrischer Strom fließt,
- Schließen mittels der Messeinrichtung (205) der beiden Schalteinrichtungen (507, 509), wenn bei angelegter elektrischer Messspannung ein zwischen dem elektrischen Referenzkontakt (513) und dem elektrischen Kontakt (641) des fünften Kontaktkelchs fließender elektrischer Strom gemessen wird.

9. Verfahren nach Anspruch 7 oder 8 bezüglich des Eingabe-/Ausgabemoduls (3) rückbezogen auf Anspruch 3, umfassend ferner:

- Schließen mittels der Messeinrichtung (205) der beiden Schalteinrichtungen (507, 509), wenn die Messeinrichtung (205) ein Durchschalten des Transistors detektiert.

10. Verfahren nach einem der Ansprüche 7 bis 9 bezüglich des Eingabe-/Ausgabemoduls (3) rückbezogen auf Anspruch 4, umfassend ferner:

Ermitteln mittels der Messeinrichtung (205) basierend auf der angelegten Messspannung und auf dem gemessenen elektrischen Strom, was für ein im Stecker (605) integriertes elektrisches Bauelement (525) eine elektrische Verbindung zwischen dem elektrischen Referenzkontakt (513) und dem elektrischen Kontakt (641) des fünften Kontaktkelchs gebildet hat, wobei insbesondere eine elektrische Eigenschaft des elektrischen Bauelements (525) ermittelt wird, wobei das elektrische Bauelement (525) insbesondere das angesteckte Datenkabel (4) ist.

11. Verfahren nach einem der Ansprüche 7 bis 10 bezüglich des Eingabe-/Ausgabemoduls (3) rückbezogen auf Anspruch 5, umfassend ferner:

- Schließen der beiden Schalteinrichtungen (507, 509) mittels der Messeinrichtung (205), wenn der elektrische Schaltkontakt (645) betätigt wird.

12. Verfahren nach einem der Ansprüche 7 bis 11 bezüglich des Eingabe-/Ausgabemoduls (3) rückbezogen auf Anspruch 6, umfassend ferner:

- Überprüfen mittels der Messeinrichtung (205) über den elektrischen Kontakt (641) des fünften Kontaktkelchs, der verschieden von den zwei und den anderen zwei der fünf Kontaktkelche ist, ob im Stecker (605) ein programmierbarer Speicher als elektrisches Bauelement (525) integriert ist,
- Schließen der beiden Schalteinrichtungen (507, 509) mittels der Messeinrichtung (205) basierend auf der Überprüfung.

13. Datenkabel (4) für ein Eingabe-/Ausgabemodul (3) für ein Bussystem (1) nach einem der Ansprüche 1 bis 6, umfassend: zwei Adernpaare, einen Stecker (605) mit fünf elektrischen Kontaktstiften und eine Schirmung, wobei vier der fünf elektrischen Kontaktstifte mit jeweils einer der Adern der zwei Adernpaare elektrisch verbunden sind, wobei zwischen dem fünften elektrischen Kontaktstift und der Schirmung zumindest ein elektrisches Bauelement (525) geschaltet ist, wobei das zumindest eine elektrische Bauelement (525) ausgewählt ist aus der folgenden Gruppe von elektrischen Bauelementen (525): Widerstand, Induktivität, Kondensator, Diode, programmierbarer Speicher, und

wobei elektrische Eigenschaften des elektrischen Bauelementes eine Datenkabellänge und /oder Betriebsparameter des Eingabe-/Ausgabemoduls codieren, wobei im programmierbaren Speicher insbesondere eine Eigenschaft des Datenkabels (4) gespeichert ist.

14. Bussystem (1), umfassend ein Eingabe-/Ausgabemodul (3) nach einem der Ansprüche 1 bis 8 und ein Datenkabel (4) nach Anspruch 13.

15. Computerprogramm, umfassend Programmcode zur Durchführung des Verfahrens nach einem der Ansprüche 7 bis 12, wenn das Computerprogramm auf einem Computer, insbesondere auf dem Eingabe-/Ausgabemodul (3) nach einem der Ansprüche 1 bis 6, ausgeführt wird.

**Claims**

1. Input/output module (3) for a bus system (1), comprising:

   - a first DC voltage supply (34) and a second DC voltage supply (35),
   - a physical interface (391), a first transformer (392), a second transformer (393), a first inductive subassembly (385), a second inductive subassembly (385), a first capacitive subassembly (386), a second capacitive subassembly (386), a first switching device (507) and a second switching device (509),
   - a socket (37) having five contact cups,
   - the five contact cups each comprising an electrical contact (641),
   - the first DC voltage supply (34) being able to be electrically connected to a respective electrical contact (641) of two of the five contact cups via the first inductive subassembly (385) by means of the first switching device (507),
   - the second DC voltage supply (35) being able to be electrically connected to a respective electrical contact (641) of two others of the five contact cups via the second inductive subassembly (385) by means of the second switching device (509),
   - the physical interface (391) being electrically connected to the respective electrical contacts (641) of two of the five contact cups via the first transformer (392) and via the first capacitive subassembly (386) in order to apply a first differential data signal to the two electrical contacts (641) of the two of the five contact cups,
   - the physical interface (391) being electrically connected to the respective electrical contacts (641) of the two others of the five contact cups via the second transformer (393) and via the second capacitive subassembly (386) in order to apply a second differential data signal to the two electrical contacts (641) of the other two of the five contact cups, and
   - a measuring device (205) for detecting a connector (605) of a four-wire data cable (4), which measuring device is configured to detect, when a connector (605) is inserted into the socket (37), whether the connector (605) comprises four or five electrical contact pins which are each plugged into one of the contact cups and are electrically connected to the respective electrical contact (641) of the contact cups,
   - the measuring device (205) being configured to close the first and second switching devices (507, 509) only when five electrical contact pins are detected in order to apply a respective supply voltage of the two DC voltage supplies (34, 35) to the corresponding plugged contact pins of the connector (605) plugged into the socket (37) via the respective electrical contacts (641) of the contact cups.

2. Input/output module (3) according to Claim 1, the measuring device (205) being configured to apply an electrical measurement voltage between the electrical contact (641) of the fifth contact cup, which differs from the two and the other two of the five contact cups, and an electrical reference contact (513) and to measure an electrical current flowing between the reference contact (513) and the electrical contact (641) of the fifth contact cup, the electrical reference contact (513) being electrically insulated from the electrical contact (641) of the fifth contact cup, the measuring device (205) being configured to close the two switching devices (507, 509) when an electrical current flowing between the electrical reference contact (513) and the electrical contact (641) of the fifth contact cup is measured when an electrical measurement voltage is applied.

3. Input/output module (3) according to Claim 2, the measuring device (205) comprising a transistor which is configured to switch on in the case of an electrical current flowing between the electrical reference contact (513) and the electrical contact (641) of the fifth contact cup, the measuring device (205) being configured to detect when the transistor switches on and to close the two switching devices (507, 509) when switching-on of the transistor is detected.

4. Input/output module (3) according to Claim 2 or 3, the measuring device (205) being configured to determine, on the basis of the applied measurement voltage and the measured electrical current, what type of electrical component (525) integrated in the connector (605) has formed an electrical connection between the electrical reference contact (513) and the electrical contact (641) of the fifth contact cup, the measuring device (205) in particular being configured to determine an electrical property of the electrical component (525), the electrical component in particular being the plugged-in data cable (4).

5. Input/output module (3) according to any one of the preceding claims, the measuring device (205) comprising an electrical switching contact (645), and the electrical contact (641) of the fifth contact cup, which differs from the two and the other two of the five contact cups, being movably mounted, with the result that, when an electrical contact pin of the connector (605) is inserted into the fifth contact cup, the electrical contact pin inserted into the fifth contact cup moves the movably mounted electrical contact (643), with the result that the latter actuates the electrical switching contact (645), the measuring device (205) being configured to close the two switching devices (507, 509) when the electrical switching contact (645) is actuated.

6. Input/output module (3) according to any one of the preceding claims, the measuring device (205) being configured to check, via the electrical contact (641) of the fifth contact cup, which differs from the two and the other two of the five contact cups, whether a programmable memory is integrated in the connector (605) as an electrical component (525) and to close the two switching devices (507, 509) on the basis of the check.

7. Method for operating an input/output module (3) according to any one of the preceding claims, comprising the following steps of:

   - using the measuring device (205) to detect (901), when a connector (605) is inserted into the socket (37), whether the connector (605) comprises four or five electrical contact pins which are each plugged into one of the contact cups and are electrically connected to the respective electrical contact (641) of the contact cups,
   - using the measuring device (205) to close (903) the two switching devices (507, 509) only when five electrical contact pins are detected, with the result that a respective supply voltage of the two DC voltage supplies (34, 35) is applied (905) to the corresponding plugged contact pins of the connector (605) plugged into the socket (37) via the respective electrical contacts (641) of the contact cups on account of the closed switching devices (507, 509).

8. Method according to Claim 7 with respect to the input/output module (3) referring back to Claim 2, also comprising:

   - using the measuring device (205) to apply an electrical measurement voltage between the electrical contact (641) of the fifth contact cup, which differs from the two and the other two of the five contact cups, and an electrical reference contact (513), and
   - using the measuring device (205) to measure whether an electrical current flows between the reference contact (513) and the electrical contact (641) of the fifth contact cup,
   - using the measuring device (205) to close the two switching devices (507, 509) when an electrical current flowing between the electrical reference contact (513) and the electrical contact (641) of the fifth contact cup is measured when an electrical measurement voltage is applied.

9. Method according to Claim 7 or 8 with respect to the input/output module (3) referring back to Claim 3, also comprising

   - using the measuring device (205) to close the two switching devices (507, 509) if the measuring device (205) detects switching-on of the transistor.

10. Method according to any one of Claims 7 to 9 with respect to the input/output module (3) referring back to Claim 4, also comprising:

   using the measuring device (205) to determine, on the basis of the applied measurement voltage and the measured electrical current, what type of electrical component (525) integrated in the connector (605) has formed an electrical connection between the electrical reference contact (513) and the electrical contact (641) of the fifth contact cup, in particular an electrical property of the electrical component (525) being determined, the electrical component (525) in particular being the plugged-in data cable (4).

11. Method according to any one of Claims 7 to 10 with respect to the input/output module (3) referring back to Claim 5, also comprising:

- using the measuring device (205) to close the two switching devices (507, 509) if the electrical switching contact (645) is actuated.

12. Method according to any one of Claims 7 to 11 with respect to the input/output module (3) referring back to Claim 6, also comprising:

- using the measuring device (205) to check, via the electrical contact (641) of the fifth contact cup, which differs from the two and the other two of the five contact cups, whether a programmable memory is integrated in the connector (605) as an electrical component (525),
- using the measuring device (205) to close the two switching devices (507, 509) on the basis of the check.

13. Data cable (4) for an input/output module (3) for a bus system (1) according to any one of Claims 1 to 6, comprising: two pairs of wires, a connector (605) with five electrical contact pins and a shield, four of the five electrical contact pins being electrically connected to a respective one of the wires of the two pairs of wires, at least one electrical component (525) being connected between the fifth electrical contact pin and the shield, the at least one electrical component (525) being selected from the following group of electrical components (525): resistor, inductance, capacitor, diode, programmable memory, and electrical properties of the electrical component coding a data cable length and/or operating parameters of the input/output module, a property of the data cable (4) in particular being stored in the programmable memory.

14. Bus system (1) comprising an input/output module (3) according to any one of Claims 1 to 8 and a data cable (4) according to Claim 13.

15. Computer program comprising program code for carrying out the method according to any one of Claims 7 to 12 when the computer program is executed on a computer, in particular on the input/output module (3) according to any one of Claims 1 to 6.

**Revendications**

1. Module d'entrée/sortie (3) pour un système de bus (1), comprenant :

- une première source de tension continue (34) et une deuxième source de tension continue (35),
- une interface physique (391), un premier transmetteur (392), un deuxième transmetteur (393), un premier sous-ensemble inductif (385), un deuxième sous-ensemble inductif (385), un premier sous-ensemble capacitif (386), un deuxième sous-ensemble capacitif (386), un premier dispositif de commutation (507) et un deuxième dispositif de commutation (509),
- une prise (37) qui possède cinq flûtes à contact,
- les cinq flûtes à contact comportant respectivement un contact électrique (641),
- la première source de tension continue (34) pouvant être reliée électriquement à un contact électrique (641) parmi deux des cinq flûtes à contact par le biais du premier sous-ensemble inductif (385) au moyen du premier dispositif de commutation (507),
- la deuxième source de tension continue (35) pouvant être reliée électriquement à un contact électrique (641) parmi deux autres des cinq flûtes à contact par le biais du deuxième sous-ensemble inductif (385) au moyen du deuxième dispositif de commutation (509),
- l'interface physique (391) étant reliée électriquement aux contacts électriques (641) respectifs de deux des cinq flûtes à contact par le biais du premier transmetteur (392) et par le biais du premier sous-ensemble capacitif (386) afin d'appliquer un premier signal de données différentiel aux deux contacts électriques (641) des deux parmi les cinq flûtes à contact,
- l'interface physique (391) étant reliée électriquement aux contacts électriques (641) respectifs des deux autres des cinq flûtes à contact par le biais du deuxième transmetteur (393) et par le biais du deuxième sous-ensemble capacitif (386) afin d'appliquer un deuxième signal de données différentiel aux deux contacts électriques (641) des deux autres des cinq flûtes à contact, et

- un dispositif de mesure (205) destiné à détecter une fiche (605) d'un câble de données (4) à quatre conducteurs, lequel est configuré pour détecter, en présence d'une fiche (605) insérée dans la prise (37), si la fiche (605) comporte quatre ou cinq broches de contact électriques qui sont respectivement insérées dans l'une des flûtes à contact et qui sont reliées électriquement avec le contact électrique (641) respectif des flûtes à contact,

- le dispositif de mesure (205) étant configuré pour fermer le premier et le deuxième dispositif de commutation (507, 509) exclusivement dans le cas d'une détection de cinq broches de contact électriques en vue d'appliquer, par le biais des contacts électriques (641) respectifs des flûtes à contact, une tension d'alimentation respective des deux sources de tension continue (34, 35) aux broches de contact insérées correspondantes de la fiche (605) insérée dans la prise (37).

2. Module d'entrée/sortie (3) selon la revendication 1, le dispositif de mesure (205) étant configuré pour appliquer une tension de mesure électrique entre le contact électrique (641) de la cinquième flûte à contact, laquelle est différente des deux et des deux autres parmi les cinq flûtes à contact, et un contact de référence (513) électrique et pour mesurer un courant électrique qui circule entre le contact de référence (513) et le contact électrique (641) de la cinquième flûte à contact, le contact de référence électrique (513) étant isolé du contact électrique (641) de la cinquième flûte à contact, le dispositif de mesure (205) étant configuré pour fermer les deux dispositifs de commutation (507, 509) lorsqu'un courant électrique circulant entre le contact de référence (513) électrique et le contact électrique (641) de la cinquième flûte à contact est mesuré alors que la tension de mesure électrique est appliquée.

3. Module d'entrée/sortie (3) selon la revendication 2, le dispositif de mesure (205) comprenant un transistor qui est configuré pour commuter à l'état passant en présence d'un courant électrique qui circule entre le contact de référence (513) électrique et le contact électrique (641) de la cinquième flûte à contact, le dispositif de mesure (205) étant configuré pour détecter une commutation à l'état passant du transistor et pour fermer les deux dispositifs de commutation (507, 509) en cas de détection d'une commutation à l'état passant du transistor.

4. Module d'entrée/sortie (3) selon la revendication 2 ou 3, le dispositif de mesure (205) étant configuré pour déterminer, en se basant sur la tension de mesure appliquée et sur le courant électrique mesuré, le type de composant électrique (525) intégré dans la fiche (605) qui a établi une liaison électrique entre le contact de référence (513) électrique et le contact électrique (641) de la cinquième flûte de contact, le dispositif de mesure (205) étant notamment configuré pour déterminer une propriété électrique du composant électrique (525), le composant électrique étant notamment le câble de données (4) attaché.

5. Module d'entrée/sortie (3) selon l'une des revendications précédentes, le dispositif de mesure (205) comprenant un contact de commutation électrique (645) et le contact électrique (641) de la cinquième flûte de contact, laquelle est différente des deux et des deux autres parmi les cinq flûtes à contact, est monté mobile, de sorte que lors d'une insertion d'une broche de contact électrique de la fiche (605) dans la cinquième flûte de contact, la broche de contact électrique insérée dans la cinquième flûte de contact déplace le contact électrique (643) monté mobile, de sorte que celui-ci actionne le contact de commutation électrique (645), le dispositif de mesure (205) étant configuré pour fermer les deux dispositifs de commutation (507, 509) lorsque le contact de commutation électrique (645) est actionné.

6. Module d'entrée/sortie (3) selon l'une des revendications précédentes, le dispositif de mesure (205) étant configuré pour contrôler par le biais du contact électrique (641) de la cinquième flûte de contact, laquelle est différente des deux et des deux autres parmi les cinq flûtes à contact, si une mémoire programmable est intégrée dans la fiche (605) en tant que composant électrique (525) et pour fermer les deux dispositifs de commutation (507, 509) en se basant sur le contrôle.

7. Procédé pour faire fonctionner un module d'entrée/sortie (3) selon l'une des revendications précédentes, comprenant les étapes suivantes :

- détection (901), au moyen du dispositif de mesure (205) en présence d'une fiche (605) insérée dans la prise (37), si la fiche (605) comporte quatre ou cinq broches de contact électriques, lesquelles sont respectivement insérées dans l'une des flûtes à contact et sont reliées électriquement au contact électrique (641) respectif des flûtes à contact,

- fermeture (903) des deux dispositifs de commutation (507, 509) au moyen du dispositif de mesure (205) exclusivement dans le cas d'une détection de cinq broches de contact électriques de sorte que, du fait des dispositifs de commutation (507, 509) fermés, une tension d'alimentation respective des deux sources de tension continue (34, 35) est appliquée (905) par le biais des contacts électriques (641) respectifs des flûtes à contact aux broches de contact insérées correspondantes de la fiche (605) insérée dans la prise (37).

8. Procédé selon la revendication 7 en référence au module d'entrée/sortie (3) rapporté à la revendication 2, comprenant en outré :

   - application, au moyen du dispositif de mesure (205), d'une tension de mesure électrique entre le contact électrique (641) de la cinquième flûte de contact, laquelle est différente des deux et des deux autres parmi les cinq flûtes à contact, et un contact de référence (513) électrique et
   - mesure, au moyen du dispositif de mesure (205), déterminant si un courant électrique circule entre le contact de référence (513) et le contact électrique (641) de la cinquième flûte de contact,
   - fermeture, au moyen du dispositif de mesure (205), des deux dispositifs de commutation (507, 509) lorsqu'un courant électrique circulant entre le contact de référence (513) électrique et le contact électrique (641) de la cinquième flûte à contact est mesuré alors que la tension de mesure électrique est appliquée.

9. Procédé selon la revendication 7 ou 8 en référence au module d'entrée/sortie (3) rapporté à la revendication 3, comprenant en outré :

   - fermeture, au moyen du dispositif de mesure (205), des deux dispositifs de commutation (507, 509) lorsque le dispositif de mesure (205) détecte une commutation à l'état passant du transistor.

10. Procédé selon l'une des revendications 7 à 9 en référence au module d'entrée/sortie (3) rapporté à la revendication 4, comprenant en outré :

    détermination, au moyen du dispositif de mesure (205) et en se basant sur la tension de mesure appliquée et sur le courant électrique mesuré, du type de composant électrique (525) intégré dans la fiche (605) qui a établi une liaison électrique entre le contact de référence (513) électrique et le contact électrique (641) de la cinquième flûte de contact, une propriété électrique du composant électrique (525) étant notamment déterminée, le composant électrique (525) étant notamment le câble de données (4) attaché.

11. Procédé selon l'une des revendications 7 à 10 en référence au module d'entrée/sortie (3) rapporté à la revendication 5, comprenant en outré :

    - fermeture des deux dispositifs de commutation (507, 509) au moyen du dispositif de mesure (205) lorsque le contact de commutation électrique (645) est actionné.

12. Procédé selon l'une des revendications 7 à 11 en référence au module d'entrée/sortie (3) rapporté à la revendication 6, comprenant en outre :

    - contrôle, au moyen du dispositif de mesure (205) et par le biais du contact électrique (641) de la cinquième flûte de contact, laquelle est différente des deux et des deux autres parmi les cinq flûtes à contact, déterminant si une mémoire programmable est intégrée dans la fiche (605) en tant que composant électrique (525)
    - fermeture des deux dispositifs de commutation (507, 509) au moyen du dispositif de mesure (205) en se basant sur le contrôle.

13. Câble de données (4) pour un module d'entrée/sortie (3) pour un système de bus (1) selon l'une des revendications 1 à 6, comprenant :

    deux paires de fils, une fiche (605) comportant cinq broches de contact électriques et un blindage, quatre des cinq broches de contact électriques étant reliées électriquement respectivement à l'un des fils des deux paires de fils, au moins un composant électrique (525) étant branché entre la cinquième broche de contact et le blindage, l'au moins un composant électrique (525) étant choisi dans le groupe de composants électriques (525) suivant : résistance, inductance, condensateur, diode, mémoire programmable, et
    les propriétés électriques du composant électrique codant une longueur du câble de données et/ou des paramètres de fonctionnement du module d'entrée/sortie, une propriété du câble de données (4) étant notamment enregistrée dans la mémoire programmable.

14. Système de bus (1), comprenant un module d'entrée/sortie (3) selon l'une des revendications 1 à 8 et un câble de données (4) selon la revendication 13.

15. Programme informatique, comprenant un code de programme destiné à mettre en oeuvre le procédé selon l'une des revendications 7 à 12 lorsque le programme informatique est exécuté sur un ordinateur, notamment sur le module d'entrée/sortie (3) selon l'une des revendications 1 à 6.

Fig. 1

**Fig. 1a**

**Fig. 1b**

EP 3 195 525 B1

**Fig. 2**

**Fig. 3**

EP 3 195 525 B1

**Fig. 4**

**Fig. 5**

901 → 903 → 905

Fig. 6

**Fig. 7**

```
┌──────────┐      ┌──────────┐      ┌──────────┐      ┌──────────┐
│          │      │          │      │          │      │          │
│   1005   │◄────►│   1007   │◄────►│   1001   │◄────►│   1003   │
│          │      │          │      │          │      │          │
└──────────┘      └──────────┘      └──────────┘      └──────────┘
```

**Fig. 8**

```
                                    ┌──────────────────────────────────┐
                                    │                                  ▼
┌────────┐   ┌────────┐   ┌────────┐│   ┌────────┐   ┌────────┐
│        │   │        │   │      │ ││   │        │   │        │
│  1005  │◄─►│  1007  │◄─►│  1101 /   │◄─►│  1001  │◄─►│  1003  │
│        │   │        │   │        │   │        │   │        │
└────────┘   └────────┘   └────────┘   └────────┘   └────────┘
```

EP 3 195 525 B1

**Fig. 9**

EP 3 195 525 B1

**Fig. 10**

**Fig. 11**

EP 3 195 525 B1

Fig. 12

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20130093444 A1
- US 6218930 B1
- DE 102011087828 A1
- WO 002015007523 A1